(19) **Europäisches Patentamt / European Patent Office / Office européen des brevets**

(11) **EP 4 779 621 A1**

(12) **EUROPEAN PATENT APPLICATION**
published in accordance with Art. 153(4) EPC

(43) Date of publication:
**22.07.2026 Bulletin 2026/30**

(51) International Patent Classification (IPC):
***G09G 3/30*** (2006.01)

(21) Application number: **25869614.5**

(22) Date of filing: **08.08.2025**

(86) International application number:
**PCT/CN2025/113450**

(87) International publication number:
**WO 2026/113501 (04.06.2026 Gazette 2026/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **29.11.2024 CN 202411748803**

(71) Applicant: **Wuhan Tianma Microelectronics Co., Ltd.**
**Wuhan, Hubei 430205 (CN)**

(72) Inventor: **ZHANG, Wenshuai**
**Wuhan, Hubei 430205 (CN)**

(74) Representative: **Germain Maureau**
**12, rue Boileau**
**69006 Lyon (FR)**

(54) **DRIVING CIRCUIT AND DRIVING METHOD THEREFOR, DISPLAY PANEL AND DISPLAY APPARATUS**

(57) A driving circuit and a method for controlling the same, a display panel, and a display apparatus. The driving circuit is for driving a pixel circuit. Each pixel circuit comprises a driving transistor, a gate resetting transistor, a data writing transistor, and a threshold compensating transistor, where the gate resetting transistor, the data writing transistor, and the threshold compensating transistor are electrically connected to the driving transistor. The driving circuit comprises a shift register comprising stages that are cascaded, where each stage comprises a first signal outputting module and a second signal outputting module. For the pixel circuit connected to the stage, an output terminal of the first signal outputting module is electrically connected to a gate of the gate resetting transistor and/or a gate of the threshold compensating transistor, and an output terminal of the second signal outputting module is electrically connected to a gate of the data writing transistor. The number of groups of peripheral driving circuits required by the pixel circuit can be reduced, which facilies a narrow bezel of the display panel and low power consumption.

FIG. 10

EP 4 779 621 A1

## Description

The present application claims priority to Chinese Patent Application No. 202411748803.5, entitled "DRIVING CIRCUIT AND METHOD FOR CONTROLLING THE SAME, DISPLAY PANEL, AND DISPLAY APPARATUS", filed on November 29, 2024, with the China National Intellectual Property Administration, the entireties of which are incorporated herein by reference.

## TECHNICAL FIELD

The present disclosure relates to the field of display technologies, and in particular, to a driving circuit, a method for controlling the driving circuit, a display panel, and a display apparatus.

## BACKGROUND

In the field of display technologies, a display panel usually comprises multiple groups of driving circuits for driving pixel circuits in a display area. In related art, the number of the groups is large, which hinders provision of a narrow bezel of the display panel and increases power consumption. There is an urgent need to solve the above problem.

## SUMMARY

In view of the above, embodiments of the present disclosure provide a driving circuit, a method for controlling the driving circuit, a display panel, and a display apparatus to address the above issue.

In a first aspect, a driving circuit driving a plurality of pixel circuits is provided according to embodiments of the present disclosure. Each pixel circuit of the plurality of pixel units comprises a driving transistor, a gate resetting transistor, a data writing transistor, and a threshold compensating transistor, where the gate resetting transistor, the data writing transistor, and the threshold compensating transistor are electrically connected to the driving transistor. The driving circuit comprises a shift register comprising a plurality of stages that are cascaded, where each stage of the plurality of stages comprises a first signal outputting module and a second signal outputting module. For the pixel circuit connected to such stage, an output terminal of the first signal outputting module is electrically connected to at least one of a gate of the gate resetting transistor or a gate of the threshold compensating transistor, and an output terminal of the second signal outputting module is electrically connected to a gate of the data writing transistor.

In a second aspect, a method for controlling the above driving circuit is provided according to embodiments of the present disclosure. Operation of the driving circuit comprises a first enabling phase and a second enabling phase, and the driving method comprises: outputting, in the first enabling phase, an active level from the first signal outputting module; and outputting, in the second enabling phase, the active level from the second signal outputting module. The first enabling phase and the second enabling phase do not overlap temporally, or the second enabling phase is within the first enabling phase.

In a third aspect, a display panel is provided according to an embodiment of the present disclosure. The display panel comprises the above driving circuit.

In a fourth aspect, a display apparatus is provided according to an embodiment of the present disclosure. The display panel comprises the above display panel.

Herein in the pixel circuit, the gate resetting transistor and/or the threshold compensating transistor are connected to the same stage of the driving circuit as the data writing transistor. Thereby, fewer groups of peripheral driving circuits are provided for the pixel circuit. For the display panel having the driving circuit and the pixel circuits, this solution facilitates small space occupation of the peripheral driving circuits and hence facilitates a narrow bezel of the display panel.

Moreover, fewer groups of peripheral driving circuits require fewer clock signals, which also reduces power consumption of the display panel.

## BRIEF DESCRIPTION OF DRAWINGS

To more clearly describe the technical solutions of the embodiments of the present disclosure, the drawings required to be used in the embodiments will be briefly introduced below. Apparently, the drawings in the following description are only some embodiments of the present disclosure. For those of ordinary skill in the art, other drawings can also be obtained according to these drawings without creative efforts.

FIG. 1 is a schematic planar view of a display panel according to an embodiment of the present disclosure.
FIG. 2 is a schematic structural diagram of a stage of a shift register according to an embodiment of the present disclosure.
FIG. 3 is a schematic diagram of a pixel circuit according to an embodiment of the present disclosure.
FIG. 4 is a schematic planar view of a display panel according to another embodiment of the present disclosure.
FIG. 5 is a schematic structural diagram of a stage of a shift register according to another embodiment of the present disclosure.
FIG. 6 is a schematic structural diagram of a stage of a shift register according to another embodiment of the present disclosure.
FIG. 7 is a schematic structural diagram of a stage of a shift register according to another embodiment of the present disclosure.

FIG. 8 is a schematic circuit diagram of a stage of a shift register as shown in FIG. 7 according to an embodiment of the present disclosure.

FIG. 9 is a schematic structural diagram of a stage of a shift register according to another embodiment of the present disclosure.

FIG. 10 is a schematic circuit diagram of a stage of a shift register as shown in FIG. 9 according to an embodiment of the present disclosure.

FIG. 11 is a schematic circuit diagram of cascaded stages of a shift register according to an embodiment of the present disclosure.

FIG. 12 is a schematic circuit diagram of a stage of a shift register as shown in FIG. 9 according to another embodiment of the present disclosure.

FIG. 13 is a schematic circuit diagram of a stage of a shift register as shown in FIG. 9 according to another embodiment of the present disclosure.

FIG. 14 is a schematic circuit diagram of a stage of a shift register as shown in FIG. 9 according to another embodiment of the present disclosure.

FIG. 15 is a schematic circuit diagram of a stage of a shift register as shown in FIG. 9 according to another embodiment of the present disclosure.

FIG. 16 is a schematic circuit diagram of a stage of a shift register as shown in FIG. 9 according to another embodiment of the present disclosure.

FIG. 17 is a timing diagram of a stage of a shift register according to an embodiment of the present disclosure.

FIG. 18 is a schematic diagram of connection of stages of a shift register according to an embodiment of the present disclosure.

FIG. 19 is a timing diagram of signals on clock-signal lines according to an embodiment of the present disclosure.

FIG. 20 is a schematic diagram of connection of stages of a shift register according to another embodiment of the present disclosure.

FIG. 21 is a schematic diagram of connection of stages of a shift register according to another embodiment of the present disclosure.

FIG. 22 is a timing diagram of signals on clock-signal lines according to another embodiment of the present disclosure.

FIG. 23 is a schematic diagram of connection of stages of a shift register according to another embodiment of the present disclosure.

FIG. 24 is a timing diagram of output signals of first signal outputting modules in stages of a shift register as shown in FIG. 23 according to an embodiment of the present disclosure.

FIG. 25 is a timing diagram of output signals of first signal outputting modules in stages of a shift register as shown in FIG. 23 according to another embodiment of the present disclosure.

FIG. 26 is a schematic circuit diagram of a shift register circuit according to another embodiment of the present disclosure.

FIG. 27 is a schematic circuit diagram of a shift register circuit according to another embodiment of the present disclosure.

FIG. 28 is a flowchart of a controlling method according to an embodiment of the present disclosure.

FIG. 29 is a schematic diagram of a display apparatus according to an embodiment of the present disclosure.

## DESCRIPTION OF EMBODIMENTS

To better understand the technical solutions of the present disclosure, the embodiments of the present disclosure will be described in detail below in conjunction with the accompanying drawings.

The described embodiments are merely some rather than all embodiments of the present disclosure. All other embodiments obtained by those of ordinary skill in the art based on the embodiments in the present disclosure without creative efforts shall fall within the protection scope of the present disclosure.

Terms used in the embodiments of the present disclosure are merely for the purpose of describing specific embodiments and are not intended to limit the present disclosure. The singular forms "a/an", "said" and "the" used in the embodiments of the present disclosure and the appended claims are also intended to comprise plural forms, unless the context clearly indicates otherwise.

The term "and/or" as used herein is merely a description of an association relationship between associated objects, indicating that there can be three relationships. For example, A and/or B can mean: A exists alone, A and B exist simultaneously, or B exists alone. In addition, the character "/" herein generally indicates that the associated objects are in an "or" relationship.

Various modifications and variations made in the present disclosure without departing from the spirit or scope of the present disclosure will be apparent to those skilled in the art. Thus, the present disclosure is intended to cover modifications and variations of the present disclosure that fall within the scope of the corresponding claims (the claimed technical solutions) and their equivalents. It should be noted that the implementations provided in the embodiments of the present disclosure can be combined with each other without contradiction.

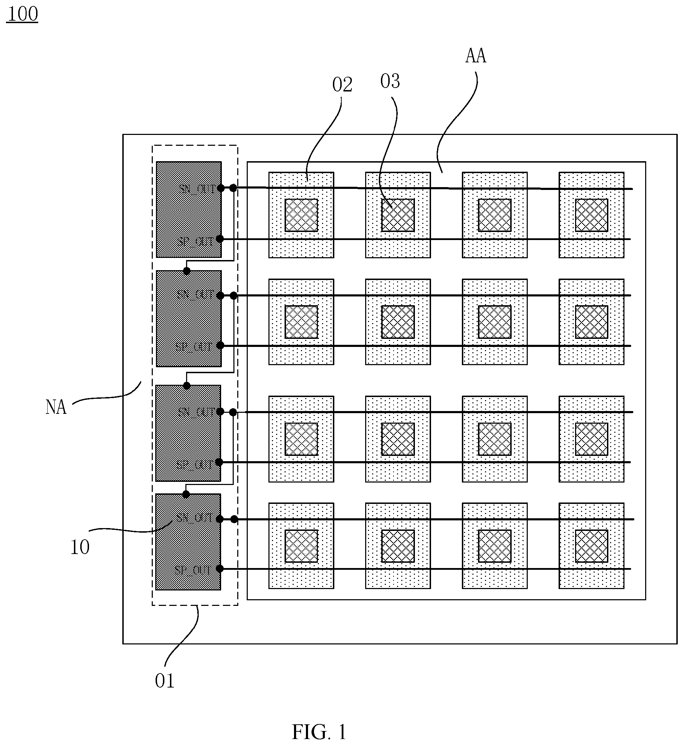

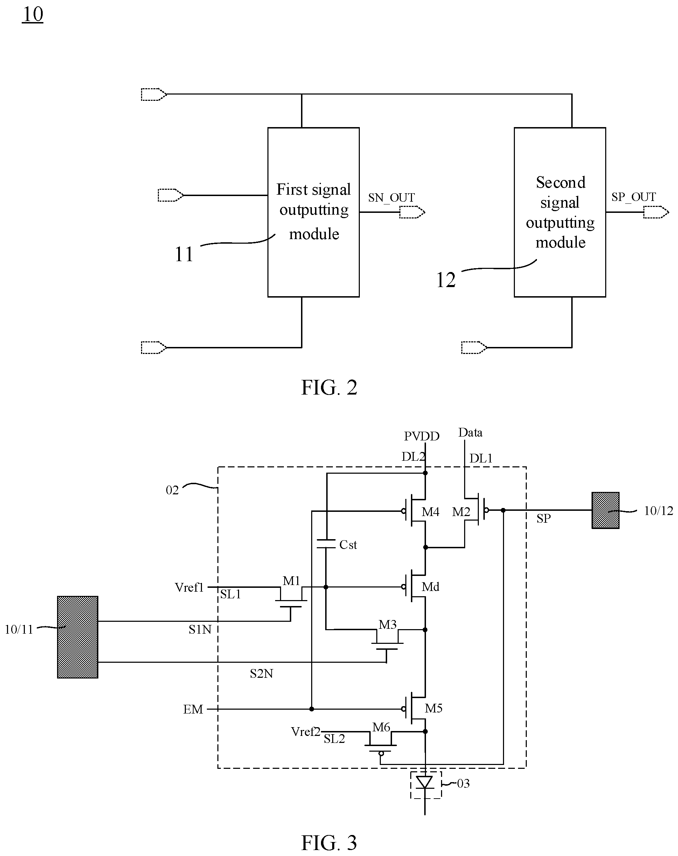

FIG. 1 is a schematic planar view of a display panel according to an embodiment of the present disclosure, and FIG. 2 is a schematic diagram of a stage of a shift register according to an embodiment of the present disclosure.

A driving circuit 01 for driving pixel circuit(s) 02 is provided according to an embodiment of the present disclosure. As shown in FIG. 1, in a possible application scenario, both the driving circuit 01 and the pixel circuits 02 are arranged in a display panel 100. The display panel 100 comprises a display area AA and a bezel area NA at a periphery of the display area AA, and the bezel area NA may surround the display area AA.

The driving circuit 01 is located in the bezel area NA, and the pixel circuits 02 are located in the display area AA. The pixel circuit 02 is electrically connected to a light-emitting device 03 for driving the light-emitting device 03 to emit light. The driving circuit 01 is electrically connected to the pixel circuits 02 for providing a gate-scanning signal to the pixel circuits 02, thereby driving the pixel circuit 02.

The driving circuit 01 comprises a shift register comprising multiple stages 10. As shown in FIG. 2, each stage 10 comprises a first signal outputting module 11 and a second signal outputting module 12. The first signal outputting module 11 and the second signal outputting module 12 are configured to transmit gate-scanning signals to different transistors in the pixel circuit 02.

Reference is made to FIG. 3, which is a schematic circuit diagram of a pixel circuit according to an embodiment of the present disclosure. The pixel circuit 02 comprises a driving transistor Md, a gate resetting transistor M1, a data writing transistor M2, and a threshold compensating transistor M3. The gate resetting transistor M1, the data writing transistor M2, and the threshold compensating transistor M are electrically connected to the driving transistor Md.

The driving transistor Md is configured to generate a current for driving a light emitting element. The gate resetting transistor M1 is configured to transmit a reset voltage to a gate of the driving transistor Md. The data writing transistor M2 is configured to transmit a voltage of a data signal to the driving transistor Md. The threshold compensating transistor M3 is configured to keep, when being turned on, a gate-source voltage of the driving transistor Md to be equal to a threshold voltage of the driving transistor Md.

In an embodiment, as shown in FIG. 3, the gate resetting transistor M1 has a first terminal electrically connected to a first reset-signal line (i.e., a line providing a reset signal) SL1, a second terminal electrically connected to the gate of the driving transistor Md, and a gate electrically connected to a first scanning line (i.e., a line providing a scanning signal) S1N. The first reset-signal line SL1 is configured to provide a first reset voltage/-signal Vref1. The data writing transistor M2 has a first terminal electrically connected to a data-signal line (i.e., a line providing a data signal) DL1, a second terminal electrically connected to a first terminal of the driving transistor Md, and a gate electrically connected to a second scanning line SP. The data-signal line DL1 is configured to provide a data voltage/signal Data. The threshold compensating transistor M3 has a first terminal electrically connected to a second terminal of the driving transistor Md, a second terminal electrically connected to the gate of the driving transistor Md, and a gate electrically connected to a third scanning line S2N.

In addition, the pixel circuit 02 further comprises a power-voltage writing transistor M4, a light-emitting control transistor M5, a light-emitting reset transistor M6, and a storage capacitor Cst. The power-voltage writing transistor M4 has a first terminal electrically connected to a first power-signal line (i.e., a line providing a power voltage) DL2, a second terminal electrically connected to the first terminal of the driving transistor Md, and a gate electrically connected to a light-emitting control-signal line (i.e., a line providing a signal for controlling light emission) EM. The first power-signal line DL2 is configured to provide a first power voltage PVDD. The light-emitting control transistor M5 has a first terminal electrically connected to the second terminal of the driving transistor Md, a second terminal electrically connected to a first terminal of the light-emitting device 03, and a gate electrically connected to the light-emitting control-signal line EM. The light-emitting reset transistor M6 has a first terminal electrically connected to a second reset-signal line SL2, a second terminal electrically connected to the first terminal of the light-emitting device 03, and a gate electrically connected to the second scanning line SP. The second reset-signal line SL2 is configured to provide a second reset voltage/signal Vref2. The storage capacitor Cst has a terminal electrically connected to the gate of the driving transistor Md and another terminal electrically connected to the first power-signal line DL2.

In an embodiment, both the gate resetting transistor M1 and the threshold compensating transistor M3 are MOSFETs. The gate resetting transistor M1 and the threshold compensating transistor M3 may be n-channel transistors, and the driving transistor Md, the data writing transistor M2, the power-voltage writing transistor M4, the light-emitting control transistor M5, and the light-emitting reset transistor M6 are p-channel transistors.

An operating process of the pixel circuit 02 may refer to the related art and is not illustrated herein.

An output terminal SN_OUT of the first signal outputting module 11 is electrically connected to the gate of the gate resetting transistor M1 and/or the gate of the threshold compensating transistor M3. An output terminal SP_OUT of the second signal outputting module 12 is electrically connected to the gate of the data writing transistor M2.

That is, the first signal outputting module 11 may provide a scanning signal to the gate of the gate resetting transistor M1 via the first scanning line S1N, and/or to the gate of the threshold compensating transistor M3 via the third scanning line S2N. The second signal outputting module 12 may provide a scanning signal to the gate of the data writing transistor M2 via the second scanning line SP. In the same pixel circuit 02, the gate resetting transistor M1 and/or the threshold compensating transistor M3 is connected to the same stage 10 as the data writing transistor M2.

FIG. 3 is only schematical and shows a case in which the first signal outputting module 11 is electrically connected to both the gate of the gate resetting transistor M1 and the gate of the threshold compensating transistor M3.

In an embodiment, an active level output by the output terminal SN_OUT of the first signal outputting module 11 may be a high level, and an active level output by the output terminal SP_OUT of the second signal outputting module 12 may be a low level.

Here in the pixel circuit 02, the gate resetting transistor M1 and/or the threshold compensating transistor M3 is electrically connected to the same stage of the driving circuit 01 as the data writing transistor M2. Thereby, fewer groups of peripheral driving circuits are provided for the pixel circuits 02. For the display panel 100 having the driving circuit 01 and the pixel circuits 02, this solution facilitates small space occupation of the peripheral driving circuits and hence facilitates a narrow bezel of the display panel 100.

Moreover, fewer groups of peripheral driving circuits of the pixel circuit 02 require fewer clock signals, which also reduces power consumption of the display panel 100.

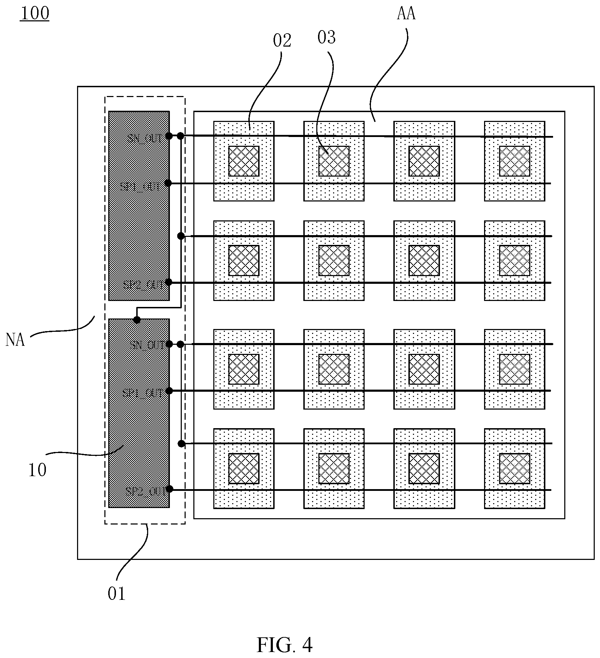

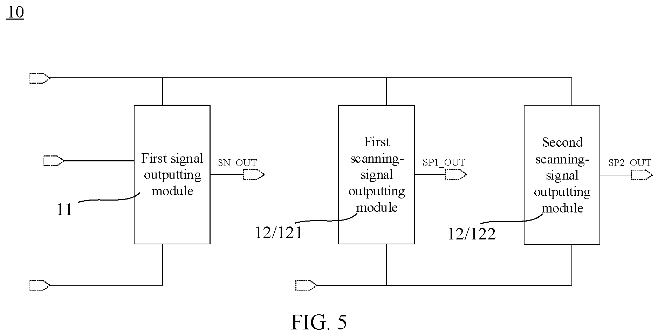

FIG. 4 is a schematic planar view of a display panel according to another embodiment of the present disclosure, and FIG. 5 is a schematic diagram of a stage of a shift register according to an embodiment of the present disclosure.

As shown in FIGS. 4 and 5, in an embodiment, the second signal outputting module 12 comprises a first scanning-signal outputting module 121 and a second scanning-signal outputting module 122. Each pixel circuit 02, of which the gate of the gate resetting transistor M2 are electrically connected to the first scanning-signal outputting module 122, and each pixel circuit 02, of which the gate of the gate resetting transistor M2 is electrically connected to the second scanning-signal outputting module 122, are located in different rows of the pixel circuits 02.

As shown in FIG. 4, in an embodiment, an output terminal SP1_OUT of the first scanning-signal outputting module 121 is electrically connected to the pixel circuits 02 of the $i^{th}$ row of the pixel units, and an output terminal SP2_OUT of the second scanning-signal outputting module 122 is electrically connected to the pixel circuits 02 of the $(i+1)^{th}$ row of the pixel units, where $i \geq 1$. That is, in the display panel 100, the same stage 10 can drive the data writing transistors M2 in of two adjacent rows the pixel circuits 02.

Both the output terminal SP1_OUT of the first scanning-signal outputting module 121 and the output terminal SP2_OUT of the second scanning-signal outputting module 122 is capable to serve the aforementioned output terminal SP_OUT of the second signal outputting module 12.

Here the same stage 10 is configured to drive two rows of the pixel circuits 02, and thus the number of stages 10 of the shift register in the driving circuit 01 can be reduced. The driving of the pixel circuits 02 can be achieved while reducing an area occupied by the driving circuit 01. It facilitates narrowing the bezel of the display panel 100.

Reference is further made to FIGS. 4 and 5. In an embodiment, the output terminal SN_OUT of the first signal outputting module 11 is electrically connected to the pixel circuits 02 of at least two rows of the pixel circuits 02.

In an embodiment, the output terminal SN_OUT of the first signal outputting module 11 is electrically connected to the pixel circuits 02 of two rows. That is, the same stage 10 is capable to drive the gate resetting transistors M1 and/or threshold compensating transistors M3 in two rows of the pixel circuits 02.

Here the output terminal SN_OUT of the first signal outputting module 11 is electrically connected to the pixel circuits 02 of the at least two rows. Hence, both the first signal outputting module 11 and the second signal outputting module 12 in the same stage 10 are capable to drive the pixel circuits 02 of the rows of the same quantity. It is less difficult to control the stage 101, and a manner of controlling the driving circuit 01 is simplified.

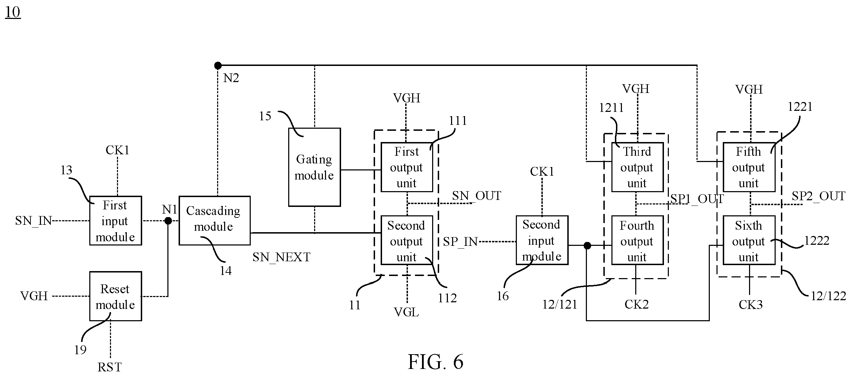

FIG. 6 is a schematic diagram of a stage of a shift register according to an embodiment of the present disclosure.

As shown in FIG. 6, in an embodiment, the first signal outputting module 11 comprises a first output unit 11 and a second output unit 112. The first output unit 11 has an input terminal configured to receive a first fixed potential and an output terminal electrically connected to the output terminal SN_OUT of the first signal outputting module 11. The second output unit 112 has an input terminal configured to receive a second fixed potential and an output terminal electrically connected to the output terminal SN_OUT of the first signal outputting module 11.

In an embodiment, the first fixed potential is a high level VGH, and the second fixed potential is a low level VGL.

The stage 10 may further comprise a first input module 13, a cascading module 14, and a gating module 15. The first input module 13 has an input terminal configured to receive a first trigger signal SN_IN, an output terminal electrically connected to a first node N1, and a control terminal configured to receive a first clock signal CK1. The first signal outputting module 11 is configured to output a signal to the pixel circuit 02 in response to the first trigger signal SN_IN.

The cascading module 14 is electrically connected to the first node N1. The cascading module 14 has a first output terminal electrically connected to a second node N2, and a second output terminal SN_NEXT electrically connected to the gating module 15 and the second output unit 112. The first output terminal of the cascading module 14 is configured to transmit a first control signal to the second node N2 according to a potential at the first node N1, and the second output terminal SN_NEXT of the cascading module 14 is configured to transmit a second control signal to the gating module 15 and the second output unit 112 according to a potential at the second node N2.

The gating module 15 is electrically connected to the second node N2. An output terminal of the gating module 15 is electrically connected to the first output unit 11. The gating module 15 is configured to transmit a third control signal to the first output unit 11 according to the potential at the second node N2 and a potential at the second output terminal SN_NEXT of the cascading module 14.

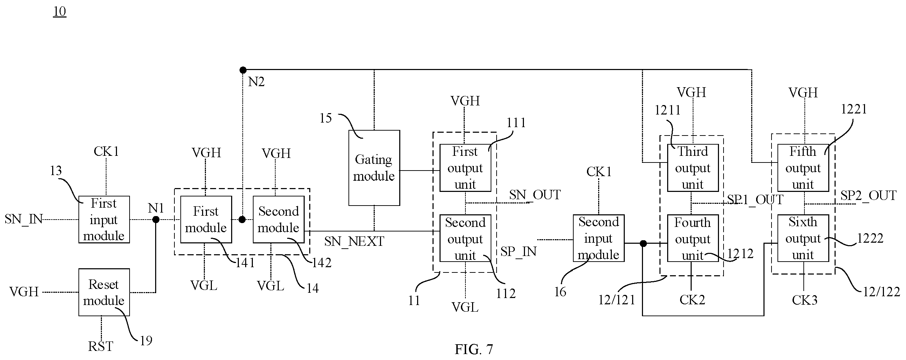

Reference is made to FIG. 7, which is a schematic diagram of a stage of the shift register according to another embodiment of the present disclosure. In an embodiment, the cascading module 14 may comprise a first module 141 and a second module 142. The first module 141 has a first input terminal configured to receive the first fixed potential VGH, a second input terminal configured to receive the second fixed potential VGL, an output terminal electrically connected to the second node N2, and a control terminal electrically connected to the first node N1. The output terminal of the first module 141 may serve as the first output terminal of the cascading module 14.

The second module 142 has a first input terminal configured to receive the first fixed potential VGH, a second input terminal configured to receive the second fixed potential VGL, an output terminal electrically connected to the second output terminal SN_NEXT of the cascading module 14, and a control terminal electrically connected to the second node N2. The output terminal of the second module 142 may serve as the second output terminal SN_NEXT of the cascading module 14, and the output terminal of the second module 142 is electrically connected to the gating module 15 and the second output unit 112.

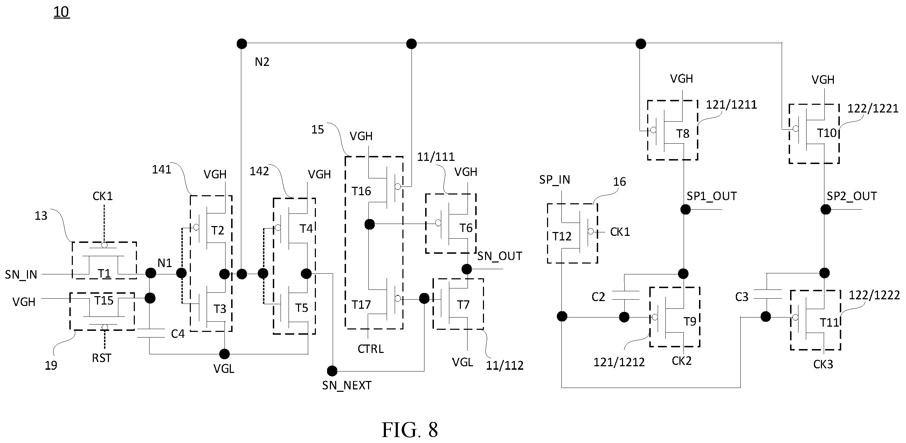

Reference is made to FIG. 8, which is a circuit diagram of a stage of a shift register shown in FIG. 7. In an embodiment, the first input module 13 comprises a first transistor T1. The first transistor T1 has a first terminal configured to receive the first trigger signal SN_IN, a second terminal electrically connected to the first node N1, and a gate configured to receive a first clock signal CK1. The first transistor T1 is capable to transmit the first trigger signal SN_IN to the first node N1.

The first module 141 may comprise a second transistor T2 and a third transistor T3. The second transistor T2 has a first terminal configured to receive the first fixed potential VGH, a second terminal electrically connected to the second node N2, and a gate electrically connected to the first node N1. The third transistor T3 has a first terminal configured to receive the second fixed potential VGL, a second terminal electrically connected to the second node N2, and a gate is electrically connected to the first node N1. The second transistor T2 and the third transistor T3 are different in type of majority carriers. The first module 141 is thus capable to transmit either the first fixed potential VGH or the second fixed potential VGL to the second node N2 according to the potential at the first node N1.

In an embodiment, the second transistor T2 is a p-channel transistor, and the third transistor T3 is an n-channel transistor. In this case, the potential at the second node N2 and the potential at the first node N1 are different in levels (i.e., a high level and a low level).

The second module 142 may comprise a fourth transistor T4 and a fifth transistor T5. The fourth transistor T4 has a first terminal configured to receive the first fixed potential VGH, a second terminal electrically connected to the output terminal of the second module 142, and a gate electrically connected to the second node N2. The fourth transistor T4 and the second transistor T2 are identical in type of majority carriers. The fifth transistor T5 has a first terminal configured to receive the second fixed potential VGL, a second terminal electrically connected to the output terminal of the second module 142, and a gate electrically connected to the second node N2. The fifth transistor T5 and the third transistor T3 are identical in type of majority carriers. The second module 142 is thus capable to transmit the first fixed potential VGH or the second fixed potential VGL to the gating module 15 and the second output unit 112 according to the potential at the second node N2. In this case, the potential at the output terminal of the second module 142 and the potential at the second node N2 have different levels.

Reference is further made to FIGS. 6 and 7. In an embodiment, the second signal outputting module 12 comprises a first scanning-signal outputting module 121 and a second scanning-signal outputting module 122, which are electrically connected to different rows of the pixel circuits 02.

The first scanning-signal outputting module 121 comprises a third output unit 1211 and a fourth output unit 1212. The third output unit 1211 has an input terminal configured to receive the first fixed potential VGH, an output terminal electrically connected to an output terminal SP1_OUT of the first scanning-signal outputting module 121, and a control terminal electrically connected to the second node N2. The fourth output unit 1212 has an input terminal configured to receive a second clock signal CK2, and an output terminal electrically connected to the output terminal SP1_OUT of the first scanning-signal outputting module 121.

The second scanning-signal outputting module 122 comprises a fifth output unit 1221 and a sixth output unit 1222. The fifth output unit 1221 has an input terminal configured to receive the first fixed potential VGH, an output terminal electrically connected to an output terminal SP2_OUT of the second scanning-signal outputting module 122, and a control terminal electrically connected to the second node N2. The sixth output unit 1222 has an input terminal configured to receive a third clock signal CK3, and an output terminal electrically connected to the output terminal SP2_OUT of the second scanning-signal outputting module 122.

In an embodiment, the stage 10 further comprises a second input module 16. The second input module 16 has an input terminal configured to receive a second trigger signal SP_IN, an output terminal coupled to the control terminal of the fourth output unit 1212 and the control terminal of the sixth output unit 1222, and a control terminal configured to receive the first clock signal CK1.

On a basis of the above configuration, the first scanning-signal outputting module 121 is configured to output either the first fixed potential VGH or the second clock signal CK2 according to the potential at the second node N2 and the potential of the second trigger signal SP_IN. The second scanning-signal outputting module 122 is configured to output either the first fixed potential VGH or the third clock signal CK3 according to the potential at the second node N2 and the potential of the second trigger signal SP_IN. The first scanning-signal outputting module 121 and the second scanning-signal outputting module 122 share the same (first) control signals, which reduces the number of transistors in the stage 10 while driving different rows of the pixel circuits 02. It facilitates implementing the narrow bezel of the display panel 100.

Reference is made to FIG. 8. In an embodiment, the first output unit 111 comprises a sixth transistor T6. The sixth transistor T6 has a first terminal configured to receive the first fixed potential VGH, a second terminal electrically connected to the output terminal of the first output unit 111, and a gate electrically connected to the output terminal of the gating module 15. The sixth transistor T6 is configured to transmit the first fixed potential VGH to the output terminal SN_OUT of the first signal outputting module 11 according to an output signal of the gating module 15. The second output unit 112 comprises a seventh transistor T7. The seventh transistor T7 has a first terminal configured to receive the second fixed potential VGL, a second terminal electrically connected to the output terminal of the second output unit 112, and a gate electrically connected to the second output terminal SN_NEXT of the cascading module 13. The seventh transistor T7 is thus capable to transmit the second fixed potential VGL to the output terminal SN_OUT of the first signal outputting module 11 according to the potential of the second output terminal SN_NEXT of the cascading module 13. The sixth transistor T6 and the seventh transistor T7 are different in type of majority carriers.

In an embodiment, the sixth transistor T6 is a p-channel transistor, and the seventh transistor T7 is an n-channel transistor.

In an embodiment, the third output unit 1211 comprises an eighth transistor T8. The eighth transistor T8 has a first terminal configured to receive the first fixed potential VGH, a second terminal electrically connected to the output terminal of the third output unit 1211, and a gate electrically connected to the second node N2. The eighth transistor T8 is thus capable to transmit the first fixed potential VGH to the output terminal SP1_OUT of the first scanning-signal outputting module 121 according to the potential of the second node N2. The fourth output unit 1212 comprises a ninth transistor T9. The ninth transistor T9 has a first terminal configured to receive the second clock signal CK2, a second terminal electrically connected to the output terminal of the fourth output unit 1212, and a gate electrically connected to the output terminal of the second input module 16. The ninth transistor T9 is thus capable to transmit the second clock signal CK2 to the output terminal SP1_OUT of the first scanning-signal outputting module 121 according to a potential at the output terminal of the second input module 16. The eighth transistor T8 and the ninth transistor T9 are identical in type of majority carriers.

In an embodiment, both the eighth transistor T8 and the ninth transistor T9 are p-channel transistors.

In an embodiment, the fifth output unit 1221 comprises a tenth transistor T10. The tenth transistor T10 has a first terminal configured to receive the first fixed potential VGH, a second terminal electrically connected to the output terminal of the fifth output unit 1221, and a gate electrically connected to the second node N2. The tenth transistor T10 is thus capable to transmit the first fixed potential VGH to the output terminal SP2_OUT of the second scanning-signal outputting module 122 according to the potential of the second node N2. The sixth output unit 1222 comprises an eleventh transistor T11. The eleventh transistor T11 has a first terminal configured to receive the third clock signal CK3, a second terminal electrically connected to the output terminal of the sixth output unit 1222, and a gate electrically connected to the output terminal of the second input module 16. The eleventh transistor T11 is thus capable to transmit the third clock signal CK3 to the output terminal SP2_OUT of the second scanning-signal outputting module 122 according to the potential of the output terminal of the second input module 16. The tenth transistor T10 and the eleventh transistor T11 are identical in type of majority carriers.

In an embodiment, both the tenth transistor T10 and the eleventh transistor T11 are p-channel transistors.

Reference is made to FIG. 8. In an embodiment, the second input module 16 comprises a twelfth transistor T12. The twelfth transistor T12 has a first terminal configured to receive the second trigger signal SP_IN, a second terminal electrically connected to the output terminal of the second input module 16, and a gate configured to receive the first clock signal CK1. The twelfth transistor T12 is thus capable to transmit the second trigger signal SP_IN to the control terminal of the fourth output unit 1212 and the control terminal of the sixth output unit 1222 according to the first clock signal CK1.

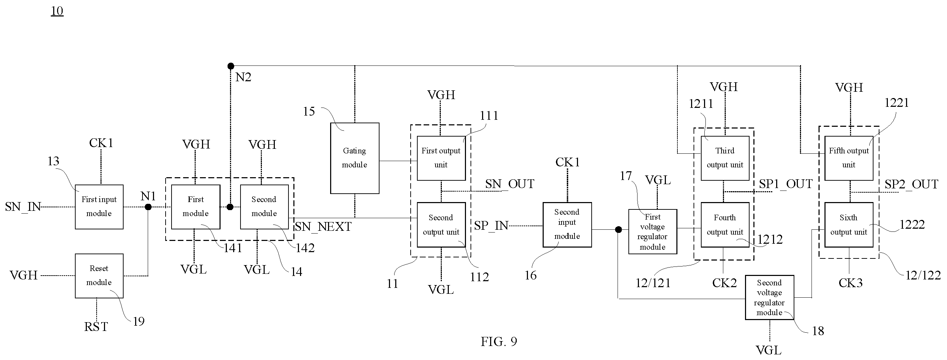

FIG. 9 is a schematic diagram of a stage of the shift register according to another embodiment of the present disclosure.

Reference is made to FIG. 9. In an embodiment, the output terminal of the second input module 16 is coupled to the fourth output unit 1212 via a first voltage regulating module 17 and the output terminal of the second input module 16 is coupled to the sixth output unit 1222 via a second voltage regulating module 18. A control terminal of the first voltage regulating module 17 and a control terminal of the second voltage regulating module 18 are both configured to receive a fixed potential. During the operation of the stage 10, the first voltage regulating module 17 and the second voltage regulating module 18 may be kept in an on state.

Reference is made to FIG. 9. In an embodiment, the control terminal of the first voltage regulating module 17 and the control terminal of the second voltage regulating module 18 are both configured to receive the second fixed potential VGL.

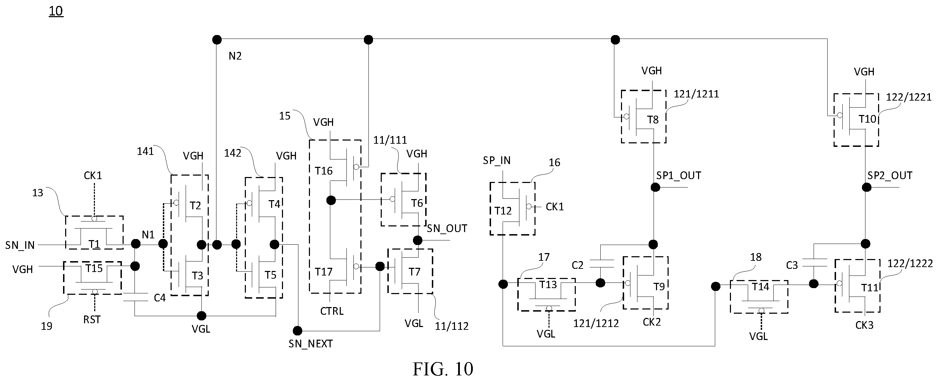

Reference is made to FIG. 10, which is a circuit diagram of a stage of a shift register as shown in FIG. 9. In an embodiment, the first voltage regulating module 17 comprises a thirteenth transistor T13. The thirteenth transistor T13 has a first terminal electrically connected to the output terminal of the second input module 16, a second terminal electrically connected to the control terminal of the fourth output unit 1212, and a gate electrically connected to the second fixed potential VGL. The second voltage regulating module 18 comprises a fourteenth transistor T14. The fourteenth transistor T14 has a first terminal electrically connected to the output terminal of the second input module 16, a second terminal electrically connected to the control terminal of the sixth output unit 1222, and a gate electrically connected to the second fixed potential VGL. Both the thirteenth transistor T13 and the fourteenth transistor T14 are p-channel transistors.

Here the first voltage regulating module 17 and the second voltage regulating module 18 are capable to stabilize the potential at the output terminal of the second input module 16. When the potential at the control terminal of the fourth output unit 1212 changes, the first voltage regulating module 17 reduces the impact of this potential change on the potential of the output terminal of the second input module 16, thereby help stabilize the potential at the output terminal of the second input module 16. When the potential of the control terminal of the sixth output unit 1222 changes, the second voltage regulating module 18 reduces the impact of this potential change on the potential at the output terminal of the second input module 16, thereby help stabilize the potential at the output terminal of the second input module 16. The second input module 16 can thus output the potential of the second trigger signal SP_IN more accurately.

Reference is further made to FIGS. 6, 7, and 9. In an embodiment, the stage 10 further comprises a reset module 19. The reset module 19 has an input terminal configured to receive the first fixed potential VGH, an output terminal electrically connected to the first node N1, and a control terminal electrically connected to a reset-signal line RST. The reset module 19 is configured to transmit the first fixed potential VGL to the first node N1 according to a reset signal on the reset-signal line RET, so as to reset the potential at the first node N1. That is, it can reset the potential at the output terminal SN_OUT of the first signal outputting module 11, which is also the potential at the output terminal SP_OUT of the second signal outputting module 12.

Reference is further made to FIGS. 8 and 10. In an embodiment, the reset module 19 comprises a fifteenth transistor T15. The fifteenth transistor T15 has a first terminal configured to receive the first fixed-potential line VGH, a second terminal electrically connected to the first node N1, and a gate electrically connected to the reset-signal line RST.

In an embodiment, at a start of the operation of the stage 10, the reset-signal line RST transmits an active level to turn on the reset module 19.

Here when the stage 10 needs to be reset, the reset-signal line RST transmits the active level to turn on the reset module 19, and the first node N1 receives the first fixed potential VGH and is maintained at a high level. The second transistor T2 in the cascading module 14 is turned off, and the third transistor T3 in the cascading module 14 is turned on. The third transistor T3 transmits the second fixed potential VGL to the second node N2, and the second node N2 is maintained at a low level.

In this case, the fourth transistor T4 is turned on, and the fifth transistor T5 is turned off. The fourth transistor T4 transmits the first fixed potential VGH to the second output terminal SN_NEXT of the cascading module 14, which turns on the seventh transistor T7. The seventh transistor T7 transmits the second fixed potential VGL to the output terminal SN_OUT of the first signal outputting module 11. Thereby, the output terminal SN_OUT of the first signal outputting module 11 is reset. The eighth transistor T8 and the tenth transistor T10 are turned on. The eighth transistor T8 transmits the first fixed potential VGH to the output terminal SP1_OUT of the first scanning-signal outputting module 121, and the tenth transistor T10 transmits the first fixed potential VGH to the output terminal SP2_OUT of the second scanning-signal outputting module 122. Thereby, the output terminal SP1_OUT of the first scanning-signal outputting module 121 and the output terminal SP2_OUT of the second scanning-signal outputting module 122 are also reset.

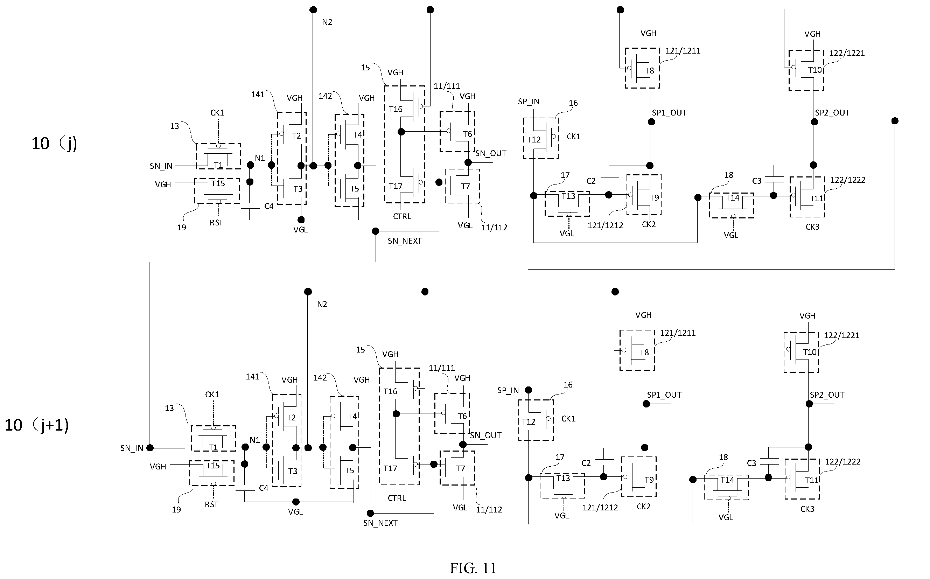

FIG. 11 is a schematic diagram of cascaded stages of the shift register according to an embodiment of the present disclosure.

Reference is made to FIG. 11. In an embodiment, the multiple cascaded stages 10 of the shift register comprise a $j^{th}$ stage 10 and a $(j+1)^{th}$ stage 10. The second output terminal SN_NEXT of the cascading module 14 in the $j^{th}$ stage 10 is electrically connected to the input terminal of the first input module 13 in the $(j+1)^{th}$ stage 10. The output terminal SP2_OUT of the second scanning-signal outputting module 122 in the $j^{th}$ stage 10 is electrically connected to the input terminal of the second input module 16 in the $(j+1)^{th}$ stage 10, where $j \geq 1$.

On a basis of the above configuration, a signal output by the second output terminal SN_NEXT of the cascading module 14 in the j$^{th}$ stage 10 serves as the first trigger signal SN_IN of the (j+1)$^{th}$ stage 10. A signal output by the output terminal SP2_OUT of the second scanning-signal outputting module 122 in the j$^{th}$ stage 10 serves as the second trigger signal SP_IN of the (j+1)$^{th}$ stage 10.

Reference is further made to FIGS. 8 and 10. In an embodiment, the gating module 15 comprises a sixteenth transistor T16 and a seventeenth transistor T17. The sixteenth transistor T16 has a first terminal configured to receive the first fixed potential VGH, a second terminal electrically connected to a control terminal of the first output unit 111, and a gate electrically connected to the second node N2. The seventeenth transistor T17 has a first terminal electrically connected to a gating-signal line CTRL, a second terminal electrically connected to the control terminal of the first output unit 111, and a gate electrically connected to the second output terminal SN_NEXT of the cascading module 14. The second terminal of the sixteenth transistor T16 and the second terminal of the seventeenth transistor T17 serve as the output terminal of the gating module 15.

Here the sixteenth transistor T16 is configured to transmit the first fixed potential VGH to the control terminal of the first output unit 111 according to the potential at the second node N2, and the seventeenth transistor T17 is configured to transmit a signal on the gating-signal line CTRL to the control terminal of the first output unit 111 according to the potential at the second output terminal SN_NEXT of the cascading module 14.

In an embodiment, both the sixteenth transistor T16 and the seventeenth transistor T17 are p-channel transistors.

When the gating-signal line CTRL transmits a high level, both the sixteenth transistor T16 and the seventeenth transistor T16 can only transmit a high level to the sixth transistor T6. Hence, the sixth transistor T6 is turned off, and the output terminal SN_OUT of the first signal outputting module 11 keeps outputting the low level of the second fixed potential VGL. In this case, the second output terminal SN_NEXT of the cascading module 14 may output a normal cascading signal.

When the gating-signal line CTRL transmits a low level, the sixteenth transistor T16 and the seventeenth transistor T17 transmit a high level and a low level to the sixth transistor T6, respectively. The sixth transistor T6 may be an on state or off state, and the output terminal SN_OUT of the first signal outputting module 11 is capable to output a scanning signal normally. In this case, the second output terminal SN_NEXT of the cascading module 14 and the output terminal SN_OUT of the first signal outputting module 11 transmit signals that are opposite in logic level.

On a basis of the above configuration, the frequency of the active-level pulses output by the output terminal SN_OUT of the first signal outputting module 11 can be controlled using the signal on the gating-signal line CTRL.

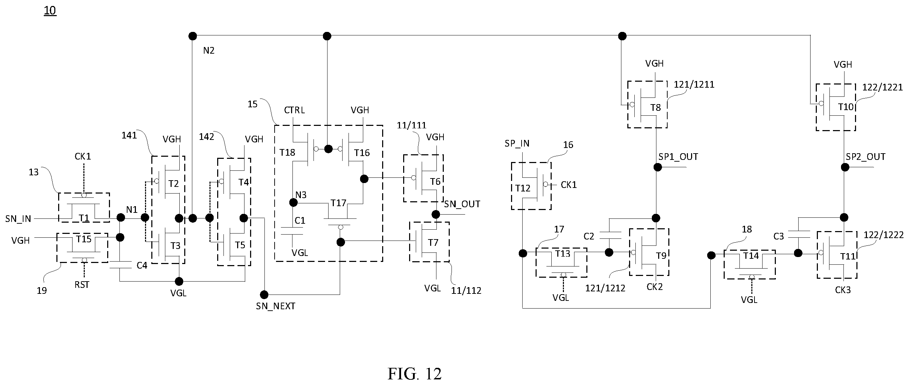

FIG. 12 shows another circuit diagram of a stage of a shift register as shown in FIG. 9.

Reference is made to FIG. 12. In an embodiment, the gating module 15 comprises a sixteenth transistor T16, a seventeenth transistor T17, and an eighteenth transistor T18. The sixteenth transistor T16 has a first terminal configured to receive the first fixed potential VGH, a second terminal electrically connected to a control terminal of the first output unit 111, and a gate electrically connected to the second node N2. The seventeenth transistor T17 has a first terminal electrically connected to a third node N3, a second terminal electrically connected to the control terminal of the first output unit 111, and a gate electrically connected to the second output terminal SN_NEXT of the cascading module 14. The eighteenth transistor T18 has a first terminal electrically connected to a gating-signal line CTRL, a second terminal electrically connected to the third node N3, and a gate electrically connected to the second node N2. The second terminal of the sixteenth transistor T16 and the second terminal of the seventeenth transistor T17 serve as the output terminal of the gating module 15.

Here the sixteenth transistor T16 is capable to transmit the first fixed potential VGH to the control terminal of the first output unit 111 according to the potential at the second node N2, the eighteenth transistor T18 is configured to transmit a potential of the signal on the gating-signal line CTRL to the third node N3 according to the potential at the second node N2, and the seventeenth transistor T17 is configured to transmit a potential of the third node N3 to the control terminal of the first output unit 111 according to the potential at the second output terminal SN_NEXT of the cascading module 14.

In an embodiment, the sixteenth transistor T16, the seventeenth transistor T17, and the eighteenth transistor T18 are all p-channel transistors.

When the gating-signal line CTRL transmits a high level, both the sixteenth transistor T16 and the seventeenth transistor T17 can only transmit the high level to the sixth transistor T6. The sixth transistor T6 is kept off, and the output terminal SN_OUT of the first signal outputting module 11 keeps outputting the low level of the second fixed potential VGL. In this case, the second output terminal SN_NEXT of the cascading module 14 outputs the normal cascading signal.

When the gating-signal line CTRL transmits a low level, the low level on the gating-signal line CTRL can be transmitted to the third node N3 via the eighteenth transistor T18. The sixteenth transistor T16 and the seventeenth transistor T17 can transmit the high level and the low level to the sixth transistor T6, respectively. The sixth transistor T6 may be in an on state or an off state, and the output terminal SN_OUT of the first signal outputting module 11 can normally output a scanning signal. In this case, the second output terminal SN_NEXT of the cascading module 14 and the output terminal SN_OUT of the first signal outputting module 11 transmit signals that are opposite in logic level.

On a basis of the above configuration, the frequency of the active-level pulses output by the output terminal SN_OUT of the first signal outputting module 11 can be controlled using the signal on the gating-signal line CTRL.

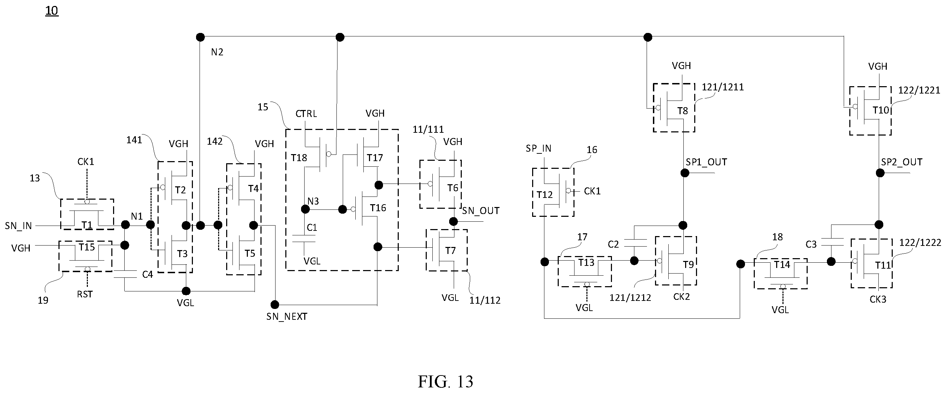

FIG. 13 is another circuit diagram of a stage of a shift register as shown in FIG. 9.

Reference is made to FIG. 13. In an embodiment, the gating module 15 comprises a sixteenth transistor T16, a seventeenth transistor T17, and an eighteenth transistor T18. The sixteenth transistor T16 has a first terminal electrically connected to the second output terminal SN_NEXT of the cascading module 14, a second terminal electrically connected to a control terminal of the first output unit 111, and a gate electrically connected to a third node N3. The seventeenth transistor T17 has a first terminal configured to receive the first fixed potential VGH, a second terminal electrically connected to the control terminal of the first output unit 111, and a gate electrically connected to the third node N3. The eighteenth transistor T18 has a first terminal electrically connected to a gating-signal line CTRL, a second terminal electrically connected to the third node N3, and a gate electrically connected to the second node N2. The second terminal of the sixteenth transistor T16 and the second terminal of the seventeenth transistor T17 serve as the output terminal of the gating module 15.

The sixteenth transistor T16 and the seventeenth transistor T17 are different in type of majority carriers, and the sixteenth transistor T16 and the eighteenth transistor T18 are identical in type of majority carriers.

In an embodiment, the sixteenth transistor T16 and the eighteenth transistor T18 are p-channel transistors, and the seventeenth transistor T17 is an n-channel transistor.

Herein the eighteenth transistor T18 is configured to transmit a potential of the signal on the gating-signal line CTRL to the third node N3 according to the potential at the second node N2, the seventeenth transistor T17 is configured to transmit the first fixed potential VGH to the control terminal of the first output unit 111 according to a potential at the third node N3, and the sixteenth transistor T16 is configured to transmit the potential of the second output terminal SN_NEXT of the cascading module 14 to the control terminal of the first output unit 111 according to the potential at the third node N3.

When the gating-signal line CTRL transmits a high level, the eighteenth transistor T18 transmits the high level to the third node N3, such that the sixteenth transistor T16 is turned off and the seventeenth transistor T17 can only transmit a high level to the control terminal of the sixth transistor T6. The sixth transistor T6 is kept off, and the output terminal SN_OUT of the first signal outputting module 11 keeps outputting the low level of the second fixed potential VGL. In this case, the second output terminal SN_NEXT of the cascading module 14 outputs the normal cascading signal.

When the gating-signal line CTRL transmits a low level, the eighteenth transistor T18 transmits the low level to the third node N3, such that the seventeenth transistor T17 is turned off and the sixteenth transistor T16 can transmit the potential of the second output terminal SN_NEXT of the cascading module 14 to the control terminal of the sixth transistor T6. The potential of the second output terminal SN_NEXT of the cascading module 14 may alter between a high level and a low level, such that the sixth transistor T6 is altered between the on state and the off state, and the output terminal SN_OUT of the first signal outputting module 11 can normally output a scanning signal. In this case, the second output terminal SN_NEXT of the cascading module 14 and the output terminal SN_OUT of the first signal outputting module 11 transmit signals that are opposite in logic level.

On a basis of the above configuration, the frequency of the active-level pulses output by the output terminal SN_OUT of the first signal outputting module 11 can be controlled using the signal on the gating-signal line CTRL.

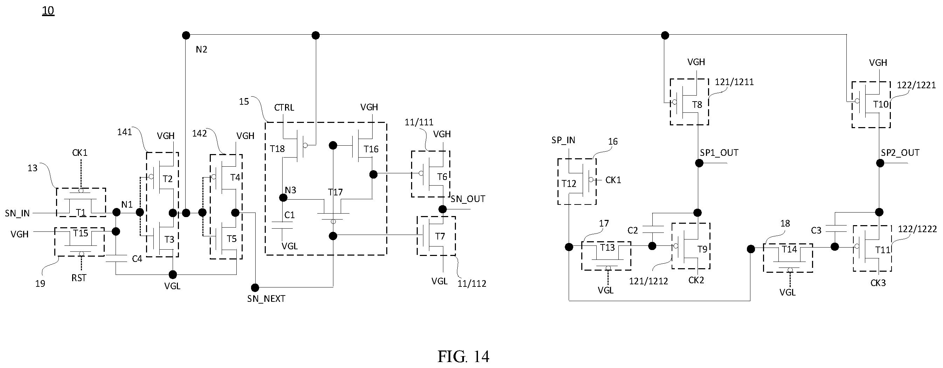

FIG. 14 is another circuit diagram of a stage of a shift register as shown in FIG. 9.

Reference is made to FIG. 14. In an embodiment, the gating module 15 comprises a sixteenth transistor T16, a seventeenth transistor T17, and an eighteenth transistor T18. The sixteenth transistor T16 has a first terminal configured to receive the first fixed potential VGH, a second terminal electrically connected to a control terminal of the first output unit 111, and a gate electrically connected to the second output terminal SN_NEXT of the cascading module 14. The seventeenth transistor T17 has a first terminal electrically connected to a third node N3, a second terminal electrically connected to the control terminal of the first output unit 111, and a gate electrically connected to the second output terminal SN_NEXT of the cascading module 14. The eighteenth transistor T18 has a first terminal electrically connected to a gating-signal line CTRL, a second terminal electrically connected to the third node N3, and a gate electrically connected to the second node N2. The second terminal of the sixteenth transistor T16 and the second terminal of the seventeenth transistor T17 serve as the output terminal of the gating module 15.

The sixteenth transistor T16 and the seventeenth transistor T17 are different in type of majority carriers, and the sixteenth transistor T16 and the eighteenth transistor T18 are different in type of majority carriers.

In an embodiment, the sixteenth transistor T16 is an n-channel transistor, and the seventeenth transistor T17 and the eighteenth transistor T18 are p-channel transistors.

Here the eighteenth transistor T18 is configured to transmit a potential of the signal on the gating-signal line CTRL to the third node N3 according to the potential at the second node N2, the seventeenth transistor T17 is configured to transmit a potential of the third node N3 to the control terminal of the first output unit 111 according to the potential at the second output terminal SN_NEXT of the cascading module 14, and the sixteenth transistor T16 is configured to transmit the first fixed potential VGH to the control terminal of the first output unit 111 according to the potential at the second output terminal SN_NEXT of the cascading module 14.

When the gating-signal line CTRL transmits a high level, the eighteenth transistor T18 transmits the high level to the third node N3. When the potential of the second output terminal SN_NEXT of the cascading module 14 is a low level, the sixteenth transistor T16 is turned off, and the seventeenth transistor T17 transmits the high level of the third node N3 to the control terminal of the sixth transistor T6, so that the sixth transistor T6 is kept off. When the potential of the second output terminal SN_NEXT of the cascading module 14 is a high level, the seventeenth transistor T17 is turned off, and the sixteenth transistor T16 transmits the high level of the first fixed potential VGH to the control terminal of the sixth transistor T6, so that the sixth transistor T6 is kept off. The output terminal SN_OUT of the first signal outputting module 11 keeps outputting the low level of the second fixed potential VGL. In this case, the second output terminal SN_NEXT of the cascading module 14 outputs the normal cascading signal.

When the gating-signal line CTRL transmits a low level, the eighteenth transistor T18 can transmit the low level to the third node N3. When the potential of the second output terminal SN_NEXT of the cascading module 14 is a low level, the seventeenth transistor T17 can transmit the low level of the third node N3 to the control terminal of the sixth transistor T6. When the potential of the second output terminal SN_NEXT of the cascading module 14 is high-level, the sixteenth transistor T16 can transmit the high level of the first fixed potential VGH to the control terminal of the sixth transistor T6. The sixth transistor T6 is thus altered between the on state and the off state, and the output terminal SN_OUT of the first signal outputting module 11 can normally output a scanning signal. In this case, the second output terminal SN_NEXT of the cascading module 14 and the output terminal SN_OUT of the first signal outputting module 11 transmit signals that are opposite in logic level.

On a basis of the above configuration, the frequency of the active-level pulses output by the output terminal SN_OUT of the first signal outputting module 11 can be controlled using the signal on the gating-signal line CTRL.

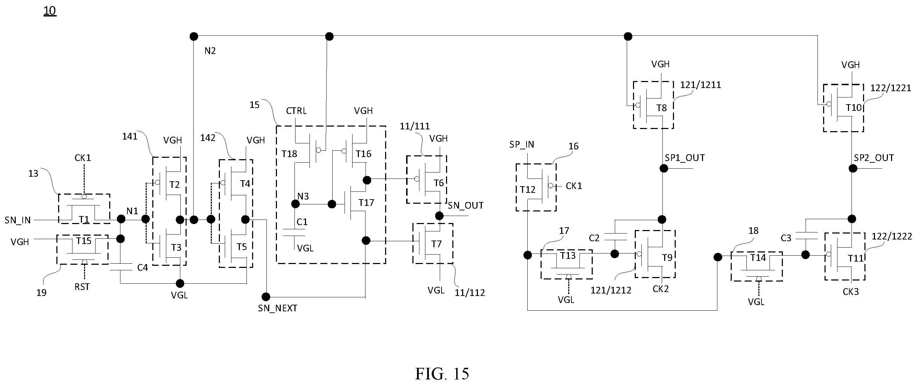

FIG. 15 is another circuit diagram of a stage of a shift register as shown in FIG. 9.

Reference is made to FIG. 15. In an embodiment, the gating module 15 comprises a sixteenth transistor T16, a seventeenth transistor T17, and an eighteenth transistor T18. The sixteenth transistor T16 has a first terminal configured to receive the first fixed potential VGH, a second terminal electrically connected to a control terminal of the first output unit 111, and a gate electrically connected to a third node N3. The seventeenth transistor T17 has a first terminal electrically connected to the second output terminal SN_NEXT of the cascading module 14, a second terminal electrically connected to the control terminal of the first output unit 111, and a gate electrically connected to a third node N3. The eighteenth transistor T18 has a first terminal electrically connected to a gating-signal line CTRL, a second terminal electrically connected to the third node N3, and a gate electrically connected to the second node N2. The second terminal of the sixteenth transistor T16 and the second terminal of the seventeenth transistor T17 serve as the output terminal of the gating module 15.

The sixteenth transistor T16 and the seventeenth transistor T17 are different in type of majority carriers, and the sixteenth transistor T16 and the eighteenth transistor T18 are identical in type of majority carriers.

In an embodiment, the sixteenth transistor T16 and the eighteenth transistor T18 are p-channel transistors, and the seventeenth transistor T17 is an n-channel transistor.

Here the eighteenth transistor T18 is configured to transmit the potential of the signal on the gating-signal line CTRL to the third node N3 according to the potential at the second node N2, the sixteenth transistor T16 is configured to transmit the first fixed potential VGH to the control terminal of the first output unit 111 according to a potential at the third node N3, and the seventeenth transistor T17 is configured to transmit the potential of the second output terminal SN_NEXT of the cascading module 14 to the control terminal of the first output unit 111 according to the potential at the third node N3.

When the gating-signal line CTRL transmits a low level, the eighteenth transistor T18 transmits the low level to the third node N3, such that the seventeenth transistor T17 is kept off and the sixteenth transistor T16 can only transmit the high level of the first fixed potential VGH to the control terminal of the sixth transistor T6. The sixth transistor T6 is kept off, and the output terminal SN_OUT of the first signal outputting module 11 keeps outputting the low level of the second fixed potential VGL. In this case, the second output terminal SN_NEXT of the cascading module 14 outputs the normal cascading signal.

When the gating-signal line CTRL transmits a high level, the eighteenth transistor T18 transmits the high level to the third node N3, such that the sixteenth transistor T16 is kept off and the seventeenth transistor T17 transmits the potential of the second output terminal SN_NEXT of the cascading module 14 to the control terminal of the sixth transistor T6. The potential of the second output terminal SN_NEXT of the cascading module 14 is altered between a high level and a low level, the sixth transistor T6 is thus altered between the on state and the off state, and the output terminal SN_OUT of the first signal outputting module 11 can normally output a scanning signal. In this case, the second output terminal SN_NEXT of the cascading module 14 and the output terminal SN_OUT of the first signal outputting module 11 transmit signals that are opposite in logic level.

On a basis of the above configuration, the frequency of the active-level pulses output by the output terminal SN_OUT of the first signal outputting module 11 can be controlled using the signal on the gating-signal line CTRL.

Reference is further made to FIGS. 12 to 15. In an embodiment, the gating module 15 further comprises a first capacitor C1. The first capacitor C1 has a terminal electrically connected to the third node N3 and another terminal configured to receive a fixed potential.

As shown in FIGS. 12 to 15, in an embodiment, the fixed potential received by the first capacitor C1 is the second fixed potential VGL.

Here the first capacitor C1 can improve the stability of the potential at the third node N3, which further improves the accuracy of signal transmission from the third node N3 to other components in the gating module 15.

Reference is further made to FIGS. 8 and 10 to 15. In an embodiment, the stage 10 further comprises a second capacitor C2, a third capacitor C3, and a fourth capacitor C4. The second capacitor C2 has a terminal electrically connected to the output terminal of the fourth output unit 1212 and another terminal electrically connected to the control terminal of the fourth output unit 1212. On a basis of the above configuration, a signal output by the fourth output unit 1212 is utilized to stabilize the signal at the control terminal of the fourth output unit 1212, which improves the stability of the operation of the fourth output unit 1212.

The third capacitor C3 has a terminal electrically connected to the output terminal of the sixth output unit 1222 and another terminal electrically connected to the control terminal of the sixth output unit 1222. On a basis of the above configuration, a signal output by the sixth output unit 1222 is utilized to stabilize a signal of the control terminal of the sixth output unit 1222, which improves the stability of the operating state of the sixth output unit 1222.

The fourth capacitor C4 has a terminal electrically connected to the first node N1 and another terminal configured to receive a fixed potential. As an example, the fixed potential for the fourth capacitor C4 is the second fixed potential VGL. On a basis of the above configuration, the stability of the potential at the first node N1 is improved, and thus the signal transmitted from the first node N1 to the cascading module 14 is more stable.

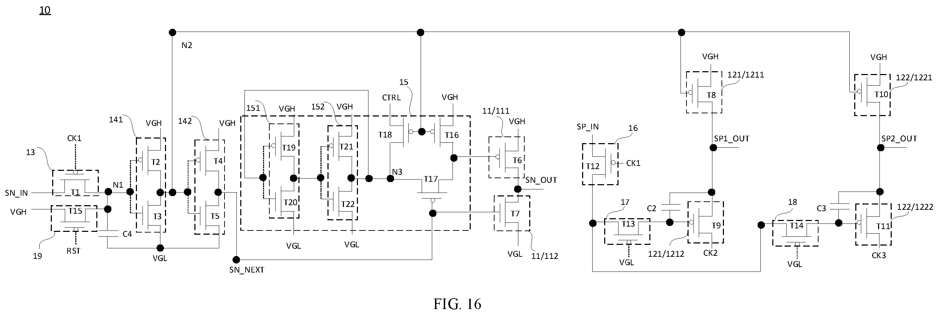

FIG. 16 is another circuit diagram of a stage of a shift register as shown in FIG. 9.

As shown in FIG. 16, in an embodiment, the gating module 15 further comprises a first logic inverter 151 and a second logic inverter 152. The first logic inverter 151 has an input terminal, which is electrically connected to an output terminal of the second logic inverter and the third node, and an output terminal, which is electrically connected to an input terminal of the second logic inverter 152. That is, the first logic inverter 151 and the second logic inverter 152 are connected in antiparallel, and both the input terminal of the first logic inverter 151 and the output terminal of the second logic inverter 152 are electrically connected to the third node N3.

Reference is made to FIG. 16. In an embodiment, the first logic inverter 151 comprises a nineteenth transistor T19 and a twelfth transistor T20. The nineteenth transistor T19 may be a p-channel transistor and the twentieth transistor T20 is an n-channel transistor. The nineteenth transistor T19 has a first terminal configured to receive the first fixed potential VGH, a second terminal electrically connected to the input terminal of the second logic inverter 152, and a gate electrically connected to the third node N3. The twentieth transistor T20 has a first terminal configured to receive the second fixed potential VGL, a second terminal electrically connected to the input terminal of the second logic inverter 152, and a gate electrically connected to the third node N3. The gates of the nineteenth transistor T19 and the twentieth transistor T20 serve as the input terminal of the first logic inverter 151, and the second terminals of the nineteenth transistor T19 and the twentieth transistor T20 serve as the output terminal of the first logic inverter 151.

In an embodiment, the second logic inverter 152 comprises a twenty-first transistor T21 and a twenty-second transistor T22. The twenty-first transistor T21 may be a p-channel transistor and the twenty-second transistor T22 is an n-channel transistor. The twenty-first transistor T21 has a first terminal configured to receive the first fixed potential VGH, a second terminal electrically connected to the third node N3, and a gate electrically connected to the output terminal of the first logic inverter 151. The twenty-second transistor T22 has a first terminal configured to receive the second fixed potential VGL, a second terminal electrically connected to a third node N3, and a gate electrically connected to the output terminal of the first logic inverter 151. The gates of the twenty-first transistor T21 and the twenty-second transistor T22 serve as the input terminal of the second logic inverter 152, and the second terminals of the twenty-first transistor T21 and the twenty-second transistor T22 serve as the output terminal of the second logic inverter 152.

Here a potential at the third node N3 is inverted by the first logic inverter 151 and then inverted by the second logic inverter 152, i.e., it is maintained with reference to itself, such that the third node N3 is stabilized at its current potential. Even when the potential of the third node N3 is subject to slight fluctuations, the first fixed potential VGH or second fixed potential VGL connected to the second logic inverter 152 refreshes the potential of the third node N3 to stabilize the potential at the third node N3. Hence, the potential at the third node N3 is more stable.

The difference between the stage of the shift register as shown in FIG. 16 and the stage of the shift register as shown in FIG. 12 lies in that the first capacitor C1 in FIG. 12 is replaced by the structure of the first logic inverter 151 and the second logic inverter 152 in FIG. 16. The first capacitor C1 in FIGS. 13 to 15 may also be replaced by the structure of the first logic inverter 151 and the second logic inverter 152 in FIG. 16.

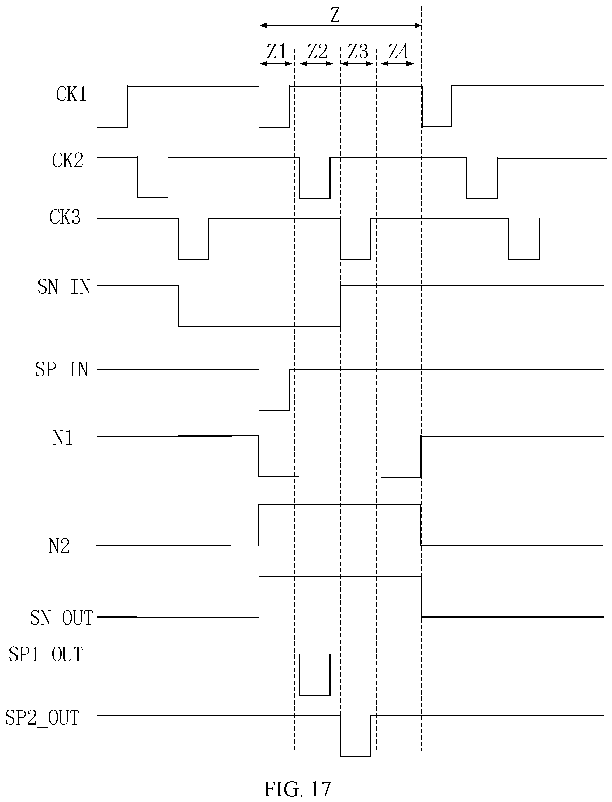

FIG. 17 is a timing diagram of a stage of a shift register according to an embodiment of the present disclosure.

To facilitate understanding of the technical solutions of the present disclosure, a exemplary process of the stage as shown in FIG. 10 outputting the active level is illustrated below in conjunction with FIGS. 10 and 17. In this example, the gating-signal line CTRL transmits a low level, the active level output by the first signal outputting module 11 is a high level, and the active level output by the second signal outputting module 12 is a low level. A signal outputting phase Z of the stage 10 comprises a first phase Z1, a second phase Z2, a third phase Z3, and a fourth phase Z4, which follows the above-listed temporal sequence.

In the first phase Z1, the first trigger signal SN_IN is at a low level, the second trigger signal SP_IN is at a low level, the first clock signal CK1 is at a low level, and the second clock signal CK2 and the third clock signal CK3 are at high levels. The first transistor T1 is turned on, and the first transistor T1 transmits the low level of the first trigger signal SN_IN to the first node N1. The second transistor T2 is turned on, the third transistor T3 is turned off, and thus the second transistor T2 transmits the high level of first fixed potential VGH to the second node N2. The fourth transistor T4, the sixteenth transistor T16, the eighth transistor T8, and the tenth transistor T10 are turned off, the fifth transistor T5 is turned on, and thus the fifth transistor T5 transmits the low level of the second fixed potential VGL to the gates of the seventh transistor T7 and the seventeenth transistor T17. The seventh transistor T7 is turned off, the seventeenth transistor T17 is turned on, and thus the seventeenth transistor T17 transmits the low level at the gating-signal line CTRL to the gate of the sixth transistor T6. The sixth transistor T6 is turned on, and thus the sixth transistor T6 outputs the high level of the first fixed potential VGH to the output terminal SN_OUT of the first signal outputting module 11.

The twelfth transistor T12 is turned on, and thus the twelfth transistor T12 transmits the low level of the second trigger signal SP_IN to the gates of the ninth transistor T9 and the eleventh transistor T11. The ninth transistor T9 and the eleventh transistor T11 are turned on, and thus the ninth transistor T9 transmits the high level of the second clock signal CK2 to the output terminal SP1_OUT of the first scanning-signal outputting module 121, and the eleventh transistor T11 transmits the high level of the third clock signal CK3 to the output terminal SP2_OUT of the second scanning-signal outputting module 122.

In the second phase Z2, the first trigger signal SN_IN is at a low level, the second trigger signal SP_IN is at a high level, the first clock signal CK1 is at a high level, the second clock signal CK2 is at a low level, and the third clock signal CK3 is at a high level. The first transistor T1 and the fourteenth transistor T14 are turned off, the first node N1 is maintained at the low level as the previous phase, and the output terminal of the fourteenth transistor T14 is maintained at the low level as the previous phase. The ninth transistor T9 and the eleventh transistor T11 is kept on, the ninth transistor T9 transmits the low level of the second clock signal CK2 to the output terminal SP1_OUT of the first scanning-signal outputting module 121, and the eleventh transistor T11 transmits the high level of third clock signal CK3 to the output terminal SP2_OUT of the second scanning-signal outputting module 122.

The second node N2 is maintained at the high level as the previous phase. The fourth transistor T4, the sixteenth transistor T16, the eighth transistor T8, and the tenth transistor T10 are turned off, the fifth transistor T5 is turned on, and thus the fifth transistor T5 transmits the low level of the second fixed potential VGL to the gates of the seventh transistor T7 and the seventeenth transistor T17. The seventh transistor T7 is turned off, the seventeenth transistor T17 is turned on, and thus the seventeenth transistor T17 transmits the low level of the gating-signal line CTRL to the gate of the sixth transistor T6. The sixth transistor T6 is turned on, and thus the sixth transistor T6 outputs the high level of the first fixed potential VGH to the output terminal SN_OUT of the first signal outputting module 11.

In the third phase Z3, the first trigger signal SN_IN is at a high level, the second trigger signal SP_IN is at a high level, the first clock signal CK1 is at a high level, the second clock signal CK2 is at a high level, and the third clock signal CK3 is at a low level. The first transistor T1 and the fourteenth transistor T14 are turned off, the first node N1 is maintained at the low level as the previous phase, and the output terminal of the fourteenth transistor T14 is maintained at the low level as the previous phase. The ninth transistor T9 and the eleventh transistor T11 is kept on, thus the ninth transistor T9 transmits the high level of the second clock signal CK2 to the output terminal SP1_OUT of the first scanning-signal outputting module 121, and the eleventh transistor T11 transmits the low level of the third clock signal CK3 to the output terminal SP2_OUT of the second scanning-signal outputting module 122.

The second node N2 is maintained at the high level as the previous phase. The fourth transistor T4, the sixteenth transistor T16, the eighth transistor T8, and the tenth transistor T10 are turned off, the fifth transistor T5 is turned on, and thus the fifth transistor T5 transmits the low level of the second fixed potential VGL to the gates of the seventh transistor T7 and the seventeenth transistor T17. The seventh transistor T7 is turned off, the seventeenth transistor T17 is turned on, and thus the seventeenth transistor T17 transmits the low level of the gating-signal line CTRL to the gate of the sixth transistor T6. The sixth transistor T6 is turned on, and thus the sixth transistor T6 outputs the high level of the first fixed potential VGH to the output terminal SN_OUT of the first signal outputting module 11.

In the fourth phase Z4, the first trigger signal SN_IN, the second trigger signal SP_IN, the first clock signal CK1, the second clock signal CK2, and the third clock signal CK3 are all at high levels. The first transistor T1 and the fourteenth transistor T14 are kept off, the first node N1 is maintained at the low level as the previous phase, and the output terminal of the fourteenth transistor T14 is maintained at the low level as the previous phase. The ninth transistor T9 and the eleventh transistor T11 is kept on, thus the ninth transistor T9 transmits the high level of the second clock signal CK2 to the output terminal SP1_OUT of the first scanning-signal outputting module 121, and the eleventh transistor T11 transmits the high level of the third clock signal CK3 to the output terminal SP2_OUT of the second scanning-signal outputting module 122.

The second node N2 is maintained at the high level as the previous phase. The fourth transistor T4, the sixteenth transistor T16, the eighth transistor T8, and the tenth transistor T10 are turned off, the fifth transistor T5 is turned on, and thus the fifth transistor T5 transmits the low level of the second fixed potential VGL to the gates of the seventh transistor T7 and the seventeenth transistor T17. The seventh transistor T7 is turned off, the seventeenth transistor T17 is turned on, and thus the seventeenth transistor T17 transmits the low level of the gating-signal line CTRL to the gate of the sixth transistor T6. The sixth transistor T6 is turned on, and the sixth transistor T6 outputs the high level of the first fixed potential VGH to the output terminal SN_OUT of the first signal outputting module 11.

In other embodiments, the timings of the first trigger signal SN_IN and the second trigger signal SP_IN are controlled, such that a time period during which the output terminal SN_OUT of the first signal outputting module 11 outputs the active level does not overlap with a time period during which the output terminal SP_OUT of the second signal outputting module 12 outputs the active level. In this case, it is possible to drive the gate resetting transistor M1 in the pixel circuit 02 independently for resetting the gate of the driving transistor Md in the pixel circuit 02.

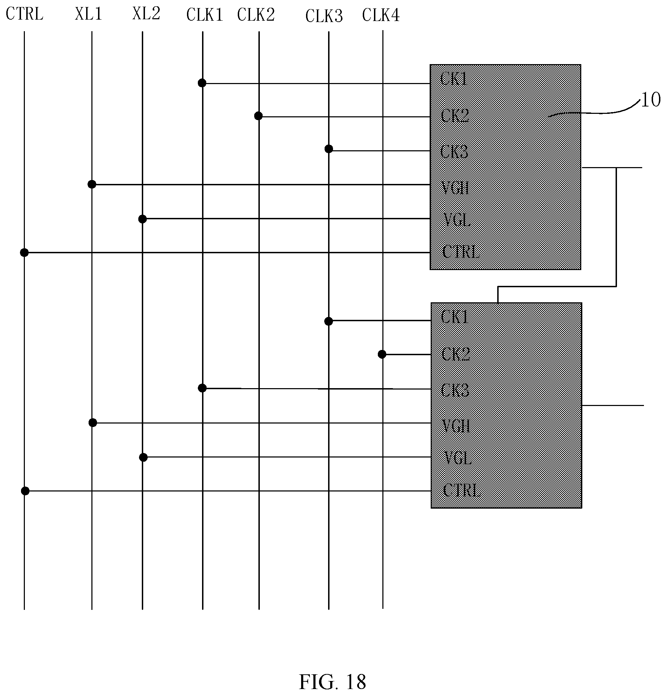

FIG. 18 is a schematical diagram of connection of stages of a shift register according to an embodiment of the present disclosure.

Reference is made to FIG. 18. In an embodiment, the stage 10 of the shift register is electrically connected to a first fixed-potential line XL1, a second fixed-potential line XL2, and the gating-signal line CTRL. The first fixed-potential line XL1 is configured to provide the first fixed potential VGH, and the second fixed-potential line XL2 is configured to provide the second fixed potential VGL. The gating-signal line CTRL is configured to provide a low level or a high level according to a requirement on control.

In an embodiment, the stage 10 of the shift register is further connected to multiple clock-signal lines which provide clock signals to the stage 10 of the shift register. As shown in FIGS. 10 and 18, in the stage 10 having an odd sequential number, the control terminal of the first input module 13 and the control terminal of the second input module 16 are both electrically connected to a first clock-signal line CLK1, the input terminal of the fourth output unit 1212 is electrically connected to a second clock-signal line CLK2, and the input terminal of the sixth output unit 1222 is electrically connected to a third clock-signal line CLK3.

A clock signal provided by the first clock-signal line CLK1 serves as the first clock signal CK1 received by the stage 10 having the odd sequential number. A clock signal provided by the second clock-signal line CLK2 serves as the second clock signal CK2 received by the stage 10 having the odd sequential number. A clock signal provided by the third clock-signal line CLK3 serves as the third clock signal CK3 received by the stage 10 having the odd sequential number.

In an stage 10 having an even sequential number, the control terminal of the first input module 13 and the control terminal of the second input module 16 are both electrically connected to the third clock-signal line CLK3, the input terminal of the fourth output unit 1212 is electrically connected to a fourth clock-signal line CLK4, and the input terminal of the sixth output unit 1222 is electrically connected to the first clock-signal line CLK1.

The clock signal provided by the third clock-signal line CLK3 serves as the first clock signal CK1 received by the stage 10 having the even sequential number. The clock signal provided by the fourth clock-signal line CLK4 serves as the second clock signal CK2 received by the stage 10 having the even sequential number. The clock signal provided by the first clock-signal line CLK1 serves as the third clock signal CK3 received by the stage 10 having the even sequential number.

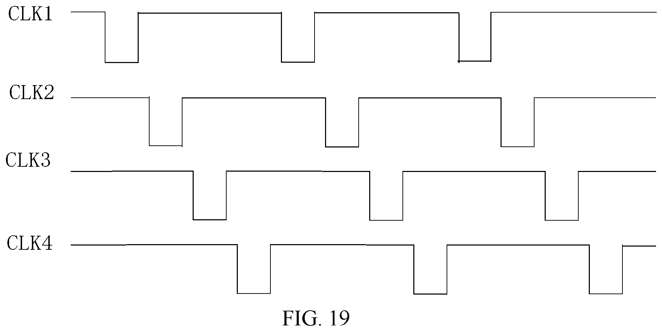

Reference is made to FIG. 19, which is a timing diagram of signals on clock-signal lines according to an embodiment of the present disclosure. In the above embodiment, the first clock-signal line CLK1, the second clock-signal line CLK2, the third clock-signal line CLK3, and the fourth clock-signal line CLK4 may transmit low-level pulses in sequence.

Here the first clock-signal line CLK1, the second clock-signal line CLK2, the third clock-signal line CLK3, and the fourth clock-signal line CLK4 are configured to provide the clock signals to the stages 10 of the shift register in the driving circuit 01. The stages 10 of the shift register in the driving circuit 01 are connected to the clock-signal lines in only two manners. The complexity of connection between the stages 10 of the shift register in the driving circuit 01 and the clock-signal lines is reduced, that is, the connection of the driving circuit 01 is simplified.

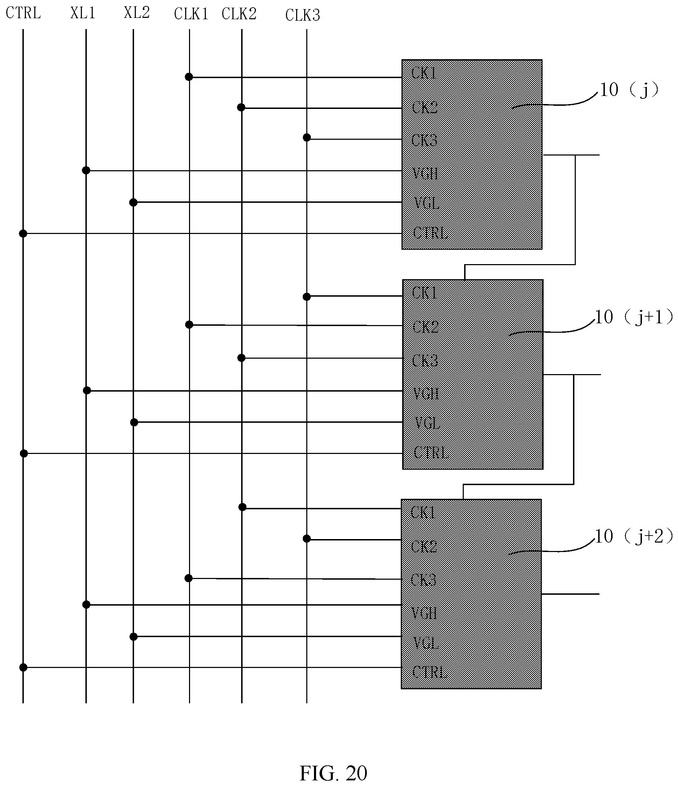

FIG. 20 is another schematic diagram of connection of stages of a shift register according to an embodiment of the present disclosure.

Reference is made to FIGS. 10 and 20. In an embodiment, the stages 10 of the shift register are connected to multiple clock-signal lines. In the $j^{th}$ stage 10, the control terminal of the first input module 13 and the control terminal of the second input module 16 are both electrically connected to a first clock-signal line CLK1, the input terminal of the fourth output unit 1212 is electrically connected to a second clock-signal line CLK2, and the input terminal of the sixth output unit 1222 is electrically connected to a third clock-signal line CLK3.

A clock signal provided by the first clock-signal line CLK1 serves as the first clock signal CK1 received by the $j^{th}$ stage 10. A clock signal provided by the second clock-signal line CLK2 serves as the second clock signal CK2 received by the $j^{th}$ stage 10. A clock signal provided by the third clock-signal line CLK3 serves as the third clock signal CK3 received by the $j^{th}$ stage 10.

In the $(j+1)^{th}$ stage 10, the control terminal of the first input module 13 and the control terminal of the second input module 16 are both electrically connected to the third clock-signal line CLK3, the input terminal of the fourth output unit 1212 is electrically connected to the first clock-signal line CLK1, and the input terminal of the sixth output unit 1222 is electrically connected to the second clock-signal line CLK2.

The clock signal provided by the third clock-signal line CLK3 serves as the first clock signal CK1 received by the $(j+1)^{th}$ stage 10. The clock signal provided by the first clock-signal line CLK1 serves as the second clock signal CK2 received by the $(j+1)^{th}$ stage 10. The clock signal provided by the second clock-signal line CLK2 serves as the third clock signal CK3 received by the $(j+1)^{th}$ stage 10.

In the $(j+2)^{th}$ stage 10, the control terminal of the first input module 13 and the control terminal of the second input module 16 are both electrically connected to the second clock-signal line CLK2, the input terminal of the fourth output unit 1212 is electrically connected to the third clock-signal line CLK3, and the input terminal of the sixth output unit 1222 is electrically connected to the first clock-signal line CLK1. There is $j \geq 1$.

The clock signal provided by the second clock-signal line CLK2 serves as the first clock signal CK1 received by the $(j+2)^{th}$ stage 10. The clock signal provided by the third clock-signal line CLK3 serves as the second clock signal CK2 received by the $(j+2)^{th}$ stage 10. The clock signal provided by the first clock-signal line CLK1 serves as the third clock signal CK3 received by the $(j+2)^{th}$ stage 10.

Reference is made to FIG. 19. In the above embodiment, the first clock-signal line CLK1, the second clock-signal line CLK2, and the third clock-signal line CLK3 may transmit low-level pulses in sequence.

Here the driving circuit 01 is connected to only three clock-signal lines to meet requirements on the clock signals of each stage 10. In an aspect, the number of clock-signal lines connected to the driving circuit 01 is reduced, which lowers power consumption. In another aspect, the loads are balanced among the first clock-signal line CLK1, the second clock-signal line CLK2, and the third clock-signal line CLK3 during transmission of the clock signals. Thus, differences between signals output by the stages of the shift register, due to unbalanced loads on the clock-signal lines, are suppressed.

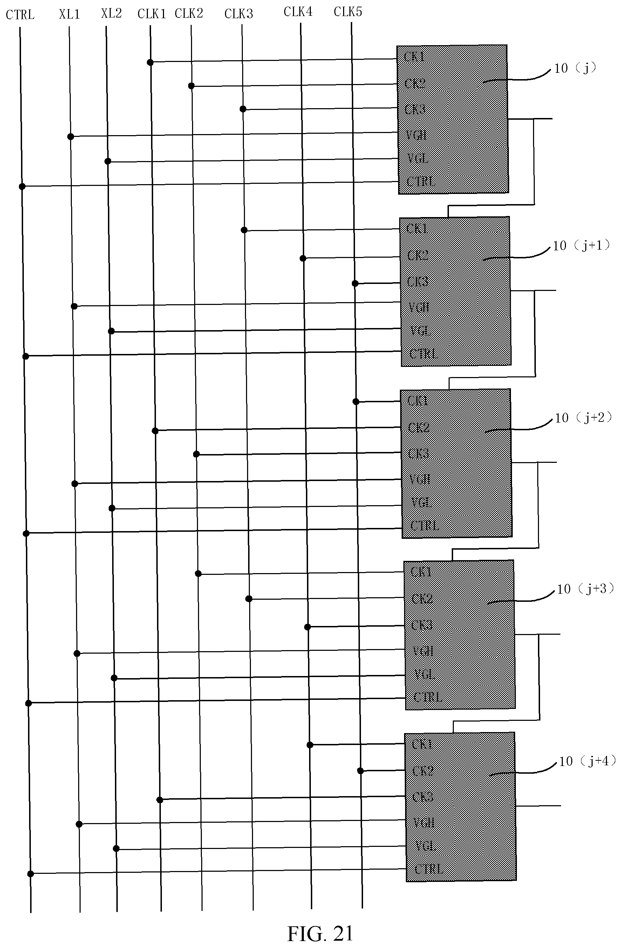

FIG. 21 is another schematic diagram of connection of stages of a shift register according to an embodiment of the present disclosure.

Reference is made to FIGS. 10 and 21. In an embedment, the stages 10 of the shift register are connected to multiple clock-signal lines. In the $j^{th}$ stage 10, the control terminal of the first input module 13 and the control terminal of the second input module 16 are both electrically connected to a first clock-signal line CLK1, the input terminal of the fourth output unit 1212 is electrically connected to a second clock-signal line CLK2, and the input terminal of the sixth output unit 1222 is electrically connected to a third clock-signal line CLK3.

A clock signal provided by the first clock-signal line CLK1 serves as the first clock signal CK1 received by the $j^{th}$ stage 10. A clock signal provided by the second clock-signal line CLK2 serves as the second clock signal CK2 received by the $j^{th}$ stage 10. A clock signal provided by the third clock-signal line CLK3 serves as the third clock signal CK3 received by the $j^{th}$ stage 10.

In the $(j+1)^{th}$ stage 10, the control terminal of the first input module 13 and the control terminal of the second input module 16 are both electrically connected to the third clock-signal line CLK3, the input terminal of the fourth output unit 1212 is electrically connected to a fourth clock-signal line CLK4, and the input terminal of the sixth output unit 1222 is electrically connected to a fifth clock-signal line CLK5.

The clock signal provided by the third clock-signal line CLK3 serves as the first clock signal CK1 received by the $(j+1)^{th}$ stage 10. A clock signal provided by the fourth clock-signal line CLK4 serves as the second clock signal CK2 received by the $(j+1)^{th}$ stage 10. A clock signal provided by the fifth clock-signal line CLK5 serves as the third clock signal CK3 received by the $(j+1)^{th}$ stage 10.

In the $(j+2)^{th}$ stage 10, the control terminal of the first input module 13 and the control terminal of the second input module 16 are both electrically connected to the fifth clock-signal line CLK5, the input terminal of the fourth output unit 1212 is electrically connected to the first clock-signal line CLK1, and the input terminal of the sixth output unit 1222 is electrically connected to the second clock-signal line CLK2.

The clock signal provided by the fifth clock-signal line CLK5 serves as the first clock signal CK1 received by the $(j+2)^{th}$ stage 10. The clock signal provided by the first clock-signal line CLK1 serves as the second clock signal CK2 received by the $(j+2)^{th}$ stage 10. The clock signal provided by the second clock-signal line CLK2 serves as the third clock signal CK3 received by the $(j+2)^{th}$ stage 10.

In a $(j+3)^{th}$ stage 10, the control terminal of the first input module 13 and the control terminal of the second input module 16 are both electrically connected to the second clock-signal line CLK2, the input terminal of the fourth output unit 1212 is electrically connected to the third clock-signal line CLK3, and the input terminal of the sixth output unit 1222 is electrically connected to the fourth clock-signal line CLK4.

The clock signal provided by the second clock-signal line CLK2 serves as the first clock signal CK1 received by the $(j+3)^{th}$ stage 10. The clock signal provided by the third clock-signal line CLK3 serves as the second clock signal CK2 received by the $(j+3)^{th}$ stage 10. The clock signal provided by the fourth clock-signal line CLK4 serves as the third clock signal CK3 received by the $(j+3)^{th}$ stage 10.

In the $(j+4)^{th}$ stage 10, the control terminal of the first input module 13 and the control terminal of the second input module 16 are both electrically connected to the fourth clock-signal line CLK4, the input terminal of the fourth output unit 1212 is electrically connected to the fifth clock-signal line CLK5, and the input terminal of the sixth output unit 1222 is electrically connected to the first clock-signal line CLK1. There is $j \geq 1$.

The clock signal provided by the fourth clock-signal line CLK4 serves as the first clock signal CK1 received by the $(j+4)^{th}$ stage 10. The clock signal provided by the fifth clock-signal line CLK5 serves as the second clock signal CK2 received by the $(j+4)^{th}$ stage 10. The clock signal provided by the first clock-signal line CLK1 serves as the third clock signal CK3 received by the $(j+4)^{th}$ stage 10.

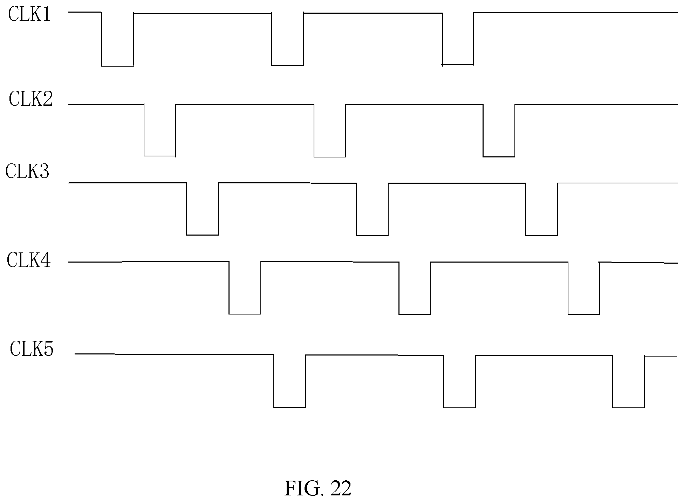

Reference is made to FIG. 22, which is another timing diagram of signals on clock-signal lines according to an embodiment of the present disclosure. In the above embodiment, the first clock-signal line CLK1, the second clock-signal line CLK2, the third clock-signal line CLK3, the fourth clock-signal line CLK4, and the fifth clock-signal line CLK5 may transmit low-level pulses in sequence.

Here the driving circuit 01 is connected to only five clock-signal lines. The number of clock-signal lines connected to the driving circuit 01 is small, and the loads are balanced among the first clock-signal line CLK1, the second clock-signal line CLK2, the third clock-signal line CLK3, the fourth clock-signal line CLK4, and the fifth clock-signal line CLK5 during transmission of the clock signals. Thus, differences between signals output by the stages of the shift register, due to unbalanced loads on the clock-signal lines, are suppressed.

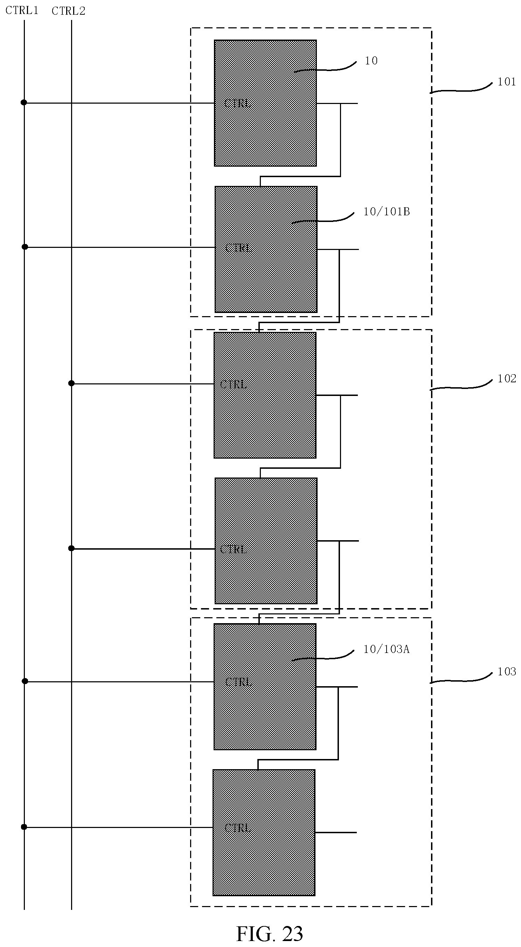

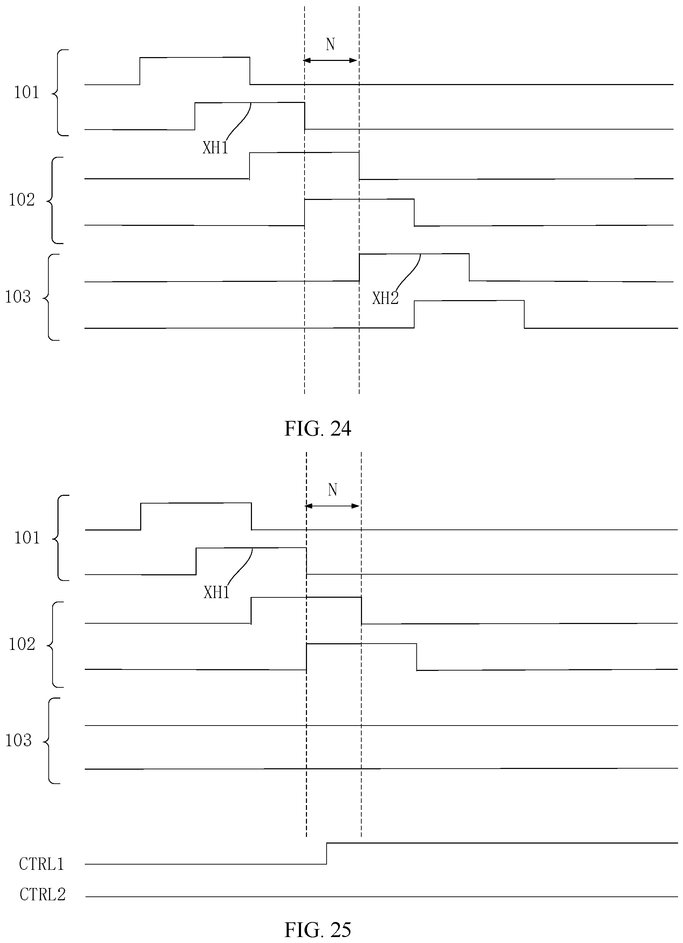

FIG. 23 is another schematic diagram of connection of stages of a shift register, and FIG. 24 is a timing diagram of output signals of first signal outputting modules in stages of a shift register as shown in FIG. 23.

Reference is made to FIGS. 8 and 10 to 16. In an embodiment, the gating module 15 is electrically connected to a gating-signal line CTRL, and the gating module 15 is configured to transmit the third control signal to the first output unit 111 according to a signal on the gating-signal line CTRL.

Reference is made to FIGS. 8 and 10. In an embodiment, the first terminal of the seventeenth transistor T17 in the gating module 15 is electrically connected to the gating-signal line CTRL, and the seventeenth transistor T17 is configured to transmit the signal on the gating-signal line CTRL to the control terminal of the first output unit 111.

Reference is made to both FIGS. 23 and 24. In an embodiment, the driving circuit 01 is electrically connected to at least two gating-signal lines CTRL, which comprise a first gating-signal line CTRL1 and a second gating-signal line CTRL2. The cascaded stages 10 of the shift register comprise stages 101 in a first region, stages 101 in a second region, and stages 103 in a third region. The second region is located between the first region and the third region. The stages 101 in a first region, the stages 102 in the second region, and the stages 103 in the third region may output active levels in sequence in their scanning signals.

The stages 101 in the first region and the stages 103 in the third region are both electrically connected to the first gating-signal line CTRL1, and the stages 102 in the second region are electrically connected to the second gating-signal line CTRL2.

The last (in sequential numbers) stage 101B in the first region is the stage closest to the second region among the stages 101 in the first region. The foremost (in sequential numbers) stage 103A in the third region is the stage closest to the second region among the stages 103 in the third region.

In the operation cycle of the driving circuit 01, an enable signal output by the output terminal SN_OUT of the first signal outputting module 11 in the stage 101B may be called a first enable signal XH1, and an enable signal output by the output terminal SN_OUT of the first signal outputting module 11 in the stage 103 is called a second enable signal XH2.

In the operation cycle of the driving circuit 01, the output terminals SN_OUT of the first signal outputting modules 11 would output active levels sequentially. The last active level output by the output terminals SN_OUT of the first signal outputting modules 11 among the stages 101 in the first region is the first enable signal XH1, and the first active level output by the output terminals SN_OUT of the first signal outputting module 11 among the stages 103 in the third region is the second enable signal XH2.

An active level of the second enable signal XH2 starts after the active level of the first enable signal XH1 ends. In an embodiment, there is a gap N between the starting time of active level in the second enable signal XH2 and the ending time of the active level in the first enable signal XH1.

That is, among the stages 101 in the first region and the stages 103 in the third region that are electrically connected to the same first gating-signal line CTRL1, there is the gap N between the last active level output by the stages 101 in the first region and the first active level output by the stages 103 in the third region.

In an embodiment, a signal on the first gating-signal line CTRL1 may be configured to jump during the period of the gap N. Thus, when the stages 10 in the first region and the third-region stages are separately controlled and the display panel 100 is refreshed in a region-based manner, it is avoided that the pulses in the output signal of the output terminal SN_OUT of the first signal outputting module 11 in the stages 10 in the first region and/or the third-region are incomplete. Hence, the quality of image display is improved across different regions of the display panel 100.

Reference is made to FIG. 25, which is another timing diagram of output signals of first signal outputting modules in stages of a shift register as shown in FIG. 23. As an example, in the operation cycle of the driving circuit 01, the second gating-signal line CTRL2 transmits a low level, and the first gating-signal line CTRL1 first transmits a low level and then a high level. During the period of the gap N, the signal on the first gating-signal line CTRL1 jumps from the low level to the high level. In this case, the first signal outputting modules 11 in the stages 101 in the first region can output complete active-level pulses, and the first signal outputting modules 11 in the stages 103 in the third region are controlled to not output active levels. Hence, the display panel 100 is refreshed in the region-based manner.

When the structure of the gating module 15 comprises the sixteenth transistor T16, the seventeenth transistor T17, and the eighteenth transistor T18, as illustrated in some of the aforementioned embodiments with reference to FIGS. 12 to 16, the region-based refresh of the display panel 100 may be implemented through connecting the driving circuit 01 to only one gating-signal line CTRL.

As an example, reference is made to the stage 10 as shown in FIG. 12. It is assumed that when the signal on the gating-signal line CTRL jumps from the low level to the high level, the first signal outputting module 11 in a certain stage of the shift register is outputting a high level. As explained in the above embodiments, at this time, the second node N2 is at a high level, the eighteenth transistor T18 is turned off, and the high level on the gating-signal line CTRL cannot be written onto the third node N3. The high level on the gating-signal line CTRL is not written into the third node N3 until the first signal outputting module 11 in this stage finishes outputting a high level and returns to a low level. Hence, the active-level pulses in the output signal of the output terminal SN_OUT of the first signal outputting module 11 in this stage would not be incomplete.

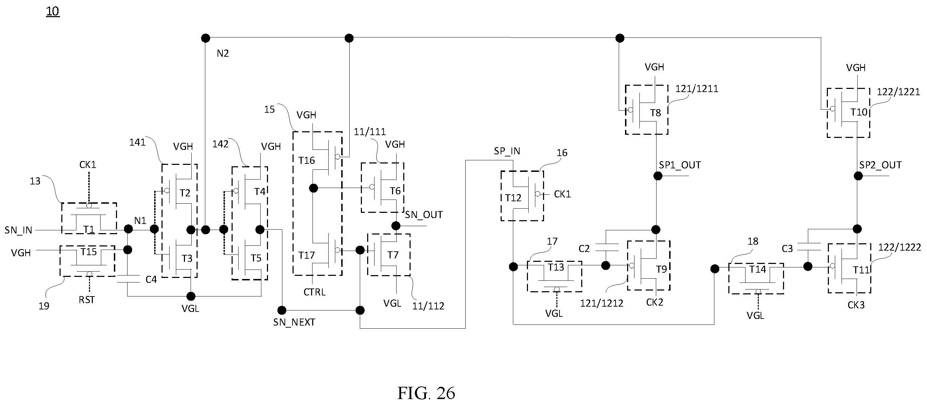

FIG. 26 is another schematic diagram of a stage of a shift register according to an embodiment of the present disclosure.

Reference is made to FIG. 26. In an embodiment, the second signal outputting module 12 comprises a first scanning-signal outputting module 121 and a second scanning-signal outputting module 122. The first scanning-signal outputting module 121 and the second scanning-signal outputting module 122 may be electrically connected to different rows of the pixel circuits 02.

The first scanning-signal outputting module 121 comprises a third output unit 1211 and a fourth output unit 1212. The third output unit 1211 has an input terminal configured to receive the first fixed potential VGH, an output terminal electrically connected to the output terminal SP1_OUT of the first scanning-signal outputting module 121, and a control terminal electrically connected to the second node N2. The fourth output unit 1212 has an input terminal configured to receive the second clock signal CK2, and an output terminal electrically connected to the output terminal SP1_OUT of the first scanning-signal outputting module 121.

The second scanning-signal outputting module 122 comprises a fifth output unit 1221 and a sixth output unit 1222. The fifth output unit 1221 has an input terminal configured to receive the first fixed potential VGH, an output terminal electrically connected to the output terminal SP2_OUT of the second scanning-signal outputting module 122, and a control terminal electrically connected to the second node N2. The sixth output unit 1222 has an input terminal configured to receive the third clock signal CK3, and an output terminal electrically connected to the output terminal SP2_OUT of the second scanning-signal outputting module 122.

The stage 10 further comprises a second input module 16. The second input module 16 has an input terminal electrically connected to the second output terminal SN_NEXT of the cascading module 15, an output terminal coupled to the control terminal of the fourth output unit 1212 and the control terminal of the sixth output unit 1222, and a control terminal configured to receive the first clock signal CK1.

The difference between the shift register circuit as shown in FIG. 26 and the shift register circuit as shown in FIG. 10 lies in that the input terminal of the second input module 16 is electrically connected to the second output terminal SN_NEXT of the cascading module 15, and thus the second trigger signal SP_IN received by the second input module 16 is the signal output by the second output terminal SN_NEXT of the cascading module 15.

As illustrated in the above embodiments of the stage 10, in the signal outputting phase Z of the stage 10, the fourth transistor T4 is turned off, and a logic level of a signal output by the fifth transistor T5 is opposite to that of a signal of the output terminal SN_OUT of the first signal outputting module 11. That is, within the signal outputting phase Z of the stage 10, the second output terminal SN_NEXT of the cascading module 15 outputs a low level, which is equivalent to that the second output terminal SN_NEXT of the cascading module 15 provides a low level to the second input module 16 within the first phase Z1. As illustrated in the above embodiments, in the second phase Z2, the third phase Z3, and the fourth phase Z4, a potential received by the input terminal of the second input module 16 does not affect the output signal of the output terminal SP1_OUT of the first scanning-signal outputting module 121 and the output terminal SP2_OUT of the second scanning-signal outputting module 122.

This configuration increases structural diversity of the stage 10 and reduces the number of cascading lines between adjacent stages 10 in the shift register. Hence, costs are reduced.

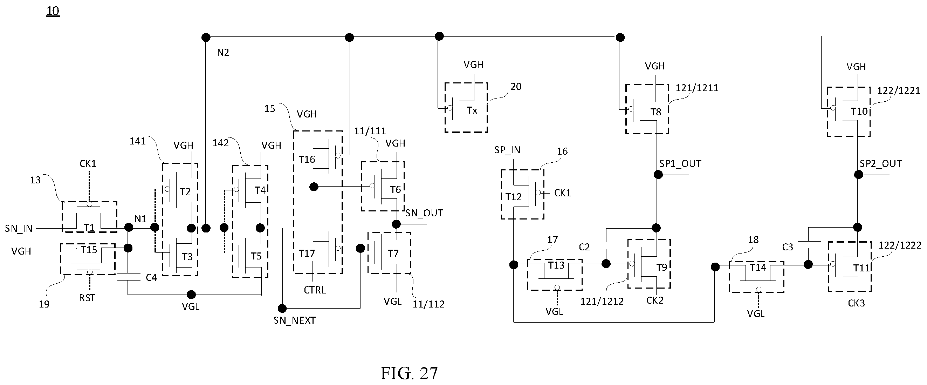

FIG. 27 is another schematic diagram of a stage of the shift register according to an embodiment of the present disclosure.

Reference is made to FIG. 27. In an embodiment, the stage 10 further comprises a third voltage regulating module 20. The third voltage regulating module has an input terminal configured to receive the first fixed potential VGH, an output terminal electrically connected to the output terminal of the second input module 16, and a control terminal electrically connected to the second node N2. The third voltage regulating module 20 is configured to transmit the high level of the first fixed potential VGH to the output terminal of the second input module 16 according to the potential at the second node N2.

As shown in FIG. 27, in an embodiment, the third voltage regulating module 20 may comprise a transistor Tx. The transistor Tx has a first terminal configured to receive the first fixed potential VGH, a second terminal electrically connected to the output terminal of the second input module 16, and a gate electrically connected to the second node N2. The transistor Tx may be a p-channel transistor.

Herein when the output terminal of the second input module 16 outputs a high level, the third voltage regulating module 20 is turned on, so that the third voltage regulating module 20 transmits the high level of the first fixed potential VGH to the output terminal of the second input module 16. Stability of the potential at the output terminal of the second input module 16 is improved, and thus the control terminals of the fourth output unit 1212 and the sixth output unit 1222 are maintained at the high potential. A coupling effect of the second clock signal CK2 on the control terminal of the fourth output unit 1212 and a coupling effect of the third clock signal CK3 on the control terminal of the sixth output unit 1222 are thereby suppressed.

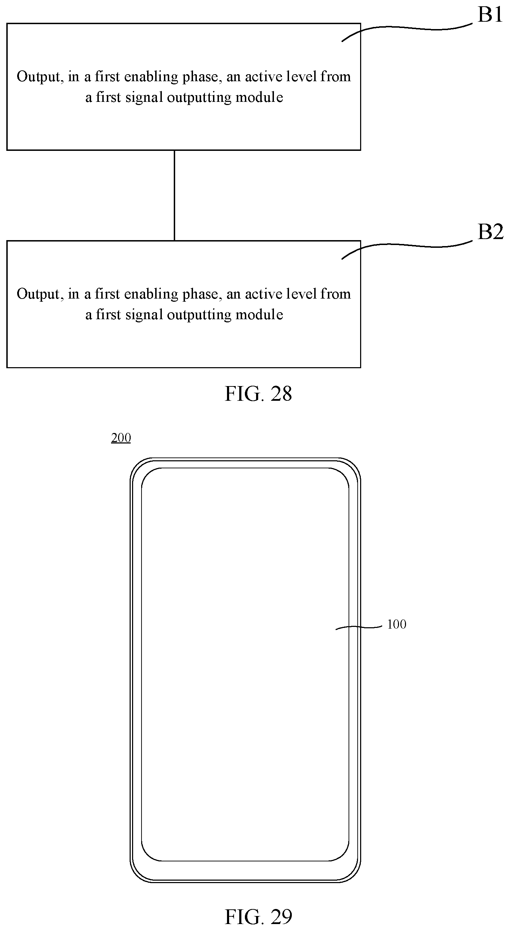

FIG. 28 is a flowchart of a controlling method according to an embodiment of the present disclosure.

Embodiments of the present disclosure further provide a method for controlling the driving circuit 01 according to the foregoing embodiments. The circuit structure of the driving circuit 01 may refer to, for example, FIGS. 8, 10, 12 to 16, and 26 to 27. Operation of the driving circuit comprises a first enabling phase and a second enabling phase. As shown in FIG. 28, the driving method comprises step B1 and step B2.

Step B1: An active level is output from the first signal outputting module in the first enabling phase.

Step B2: The active level is output from the second signal outputting module in the first enabling phase.

The first enabling phase and the second enabling phase do not overlap temporally, or the second enabling phase is within the first enabling phase.

As an example, in the driving circuit 01, the output terminal SN_OUT of the first signal outputting module 11 is only electrically connected to the gate resetting transistor M1 in the pixel circuit 02. In this case, the first enabling phase and the second enabling phase may not overlap temporally within the operating cycle of the driving circuit 01. The driving circuit 01 may first drive the pixel circuit 02 to reset the potential at the gate of the driving transistor Md and then drive the pixel circuit 02 to write the data signal.

As another example, the output terminal SN_OUT of the first signal outputting module 11 is only electrically connected to the threshold compensating transistor M3 in the pixel circuit 02. In this case, the second enabling phase may be within the first enabling phase in the operating cycle of the driving circuit 01. When the driving circuit 01 turns on the data writing transistor M2 in the pixel circuit 02, it turns on the threshold compensating transistor M3 simultaneously to write the data signal to the gate of the driving transistor Md.

As another example, when the output terminal SN_OUT of the first signal outputting module 11 is electrically connected to both the gate resetting transistor M1 and the threshold compensating transistor M3 in the pixel circuit 02, the driving circuit 01 may comprise multiple first enabling phases. In the operating cycle of the driving circuit 01, a part of the first enabling phases do not overlap with the second enabling phase, such that the driving circuit 01 drives the pixel circuit 02 to reset the gate of the driving transistor Md. Another part of the first enabling phases are the first enabling phases each of which comprises the respective second enabling phase, such that the driving circuit 01 drives the pixel circuit 02 to write the data signal.

Here in the pixel circuit 02, the gate resetting transistor M1 and/or the threshold compensating transistor M3 is electrically connected to the same stage of the driving circuit 01 as the data writing transistor M2. Thereby, fewer groups of peripheral driving circuits are provided for the pixel circuits 02. For the display panel 100 having the driving circuit 01 and the pixel circuits 02, this solution facilitates small space occupation of the peripheral driving circuits and hence facilitates a narrow bezel of the display panel 100.

Moreover, fewer groups of peripheral driving circuits of the pixel circuit 02 require fewer clock signals, which also reduces power consumption of the display panel 100.

Reference is made to FIGS. 8, 10, 12 to 16, and 26 to 27. In an embodiment, the second signal outputting module 12 comprises a first scanning-signal outputting module 121 and a second scanning-signal outputting module 122. Each pixel circuit 02, of which the gate of the gate resetting transistor M2 are electrically connected to the first scanning-signal outputting module 122, and each pixel circuit 02, of which the gate of the gate resetting transistor M2 is electrically connected to the second scanning-signal outputting module 122, are located in different rows of the pixel circuits 02. The second enabling phase comprises a first sub-phase and a second sub-phase. The step of outputting the active level from the second signal outputting module comprises step B21 and step B22.

Step B21: The active level is output from the first scanning-signal outputting module 121 in the first sub-phase.

Step B22: The active level is output from the second scanning-signal outputting module 121 in the second sub-phase.

The first sub-phase is after the second sub-phase.

In an embodiment, the first sub-phase and the second sub-phase do not overlap. The first sub-phase in this embodiment may refer to the second phase Z2 as shown in FIG. 17, and the second sub-phase in this embodiment refers to the third phase Z3 as shown in FIG. 17.

Here the same stage 10 is configured to drive two rows of the pixel circuits 02, and thus the number of stages 10 of the shift register in the driving circuit 01 can be reduced. The driving of the pixel circuits 02 can be achieved while reducing an area occupied by the driving circuit 01. It facilitates narrowing the bezel of the display panel 100.

Reference is made to FIGS. 1 and 4. Embodiments of the present disclosure further provide a display panel 100, which comprises the driving circuit 01 in any foregoing embodiment. For example, the display panel 100 may be any one of: an organic light-emitting diode (OLED) display panel, a micro light-emitting diode (Micro-LED) display panel, or a mini light-emitting diode (Mini-LED) display panel, which is not specifically limited in the present disclosure.

In the display panel 100, the driving circuit 01 is capable to drive simultaneously: (1) the gate resetting transistor M1 and/or the threshold compensating transistor M3, and (2) the data writing transistor M2, in the pixel circuit 02. The number of groups of peripheral driving circuits required by the pixel circuits 02 is reduced. It reduces the area occupied by the peripheral driving circuits and facilities a narrow bezel of the display panel 100.

Moreover, fewer groups of peripheral driving circuits of the pixel circuit 02 require fewer clock signals, which also reduces power consumption of the display panel 100.

FIG. 29 is a schematic diagram of a display apparatus according to an embodiment of the present disclosure.

Embodiments of the present disclosure further provide a display apparatus 200, as shown in FIG. 29, which comprises the display panel 100 in the above embodiment. In an embodiment, the display apparatus 200 may be an electronic device such as a mobile phone, a computer, a television, a vehicle-mounted display, or a wearable display, which is not specifically limited in the present disclosure.

Here in the pixel circuit 02 within the display apparatus 200, the gate resetting transistor M1 and/or the threshold compensating transistor M3 is electrically connected to the same stage of the driving circuit 01 as the data writing transistor M2. Thereby, fewer groups of peripheral driving circuits are provided for the pixel circuits 02. For the display panel 100 having the driving circuit 01 and the pixel circuits 02, this solution facilitates small space occupation of the peripheral driving circuits and hence facilitates a narrow bezel of the display panel 100.

Moreover, fewer groups of peripheral driving circuits of the pixel circuit 02 require fewer clock signals, which also reduces power consumption of the display apparatus 200.

The above are only preferred embodiments of the present disclosure and are not intended to limit the present disclosure. Any modification, equivalent replacement, improvement, etc., made within the spirit and principle of the present disclosure shall be comprised in the protection scope of the present disclosure.

**Claims**

1. A driving circuit for driving a plurality of pixel circuits, wherein:

   each pixel circuit of the plurality of pixel units comprises a driving transistor, a gate resetting transistor, a data writing transistor, and a threshold compensating transistor, wherein the gate resetting transistor, the data writing transistor, and the threshold compensating transistor are electrically connected to the driving transistor; the driving circuit comprises a shift register comprising a plurality of stages that are cascaded, wherein each stage of the plurality of stages comprises a first signal outputting module and a second signal outputting module, and for the pixel circuit connected to said stage:

   an output terminal of the first signal outputting module is electrically connected to at least one of a gate of the gate resetting transistor or a gate of the threshold compensating transistor, and
an output terminal of the second signal outputting module is electrically connected to a gate of the data writing transistor.

2. The driving circuit according to claim 1, wherein:

the second signal outputting module comprises a first scanning-signal outputting module and a second scanning-signal outputting module; and each pixel circuit, of which the gate of the gate resetting transistor are electrically connected to the first scanning-signal outputting module, and each pixel circuit, of which the gate of the gate resetting transistor is electrically connected to the second scanning-signal outputting module, are located in different rows of the pixel circuits.

3. The driving circuit according to claim 2, wherein:
an output terminal of the first scanning-signal outputting module is electrically connected to the $i^{th}$ row of the plurality of pixel circuits, and an output terminal of the second scanning-signal outputting module is electrically connected to the $(i+1)^{th}$ row of the plurality of pixel circuits, wherein $i \geq 1$.

4. The driving circuit according to claim 2, wherein the output terminal of the first signal outputting module is electrically connected to at least two rows of the plurality of pixel circuits.

5. The driving circuit according to claim 1, wherein:

the first signal outputting module comprises a first output unit and a second output unit; an input terminal of the first output unit is configured to receive a first fixed potential, and an output terminal of the first output unit is electrically connected to the output terminal of the first signal outputting module; and an input terminal of the second output unit is configured to receive a second fixed potential, and an output terminal of the second output unit is electrically connected to the output terminal of the first signal outputting module;
each stage of the plurality of stages further comprises a first input module, a cascading module, and a gating module, wherein:

an input terminal of the first input module is configured to receive a first trigger signal, an output terminal of the first input module is electrically connected to a first node, and a control terminal of the first input module is configured to receive a first clock signal; the cascading module is electrically connected to the first node, a first ouput terminal of the cascading module is electrically connected to a second node, and a second output terminal electrically of the cascading module is connected to the gating module and the second output unit, the first output terminal of the cascading module is configured to transmit a first control signal to the second node according to a potential at the first node, and the second output terminal of the cascading module is configured to transmit a second control signal to the gating module and the second output unit according to a potential at the second node; and
the gating module is electrically connected to the second node, an output terminal of the gating module is electrically connected to the first output unit, and the gating module is configured to transmit a third control signal to the first output unit according to the potential at the second node and a potential at the second output terminal of the cascading module.

6. The driving circuit according to claim 5, wherein:

the cascading module comprises a first module and a second module;
a first input terminal of the first module is configured to receive the first fixed potential, a second input terminal of the first module is configured to receive the second fixed potential, an output terminal of the first module is electrically connected to the second node, and a control terminal of the first module is electrically connected to the first node; and
a first input terminal of the second module is configured to receive the first fixed potential, a second input terminal of the second module is configured to receive the second fixed potential, an output terminal of the second module is electrically connected to the second output terminal of the cascading module, and a control terminal of the second module is electrically connected to the second node.

7. The driving circuit according to claim 5, wherein:

the second signal outputting module comprises a first scanning-signal outputting module and a second scanning-signal outputting module;
the first scanning-signal outputting module comprises a third output unit and a fourth output unit, wherein an input terminal of the third output unit is configured to receive the first fixed potential, an output terminal of the third output unit is electrically connected to an output terminal of the first scanning-signal outputting module, a control terminal of the third output unit is electrically connected to the second node, an input terminal of the fourth output unit is configured to receive a second clock signal, and an output terminal of the fourth output unit is electrically connected to the output terminal of the first scanning-signal outputting module;

the second scanning-signal outputting module comprises a fifth output unit and a sixth output unit, wherein an input terminal of the fifth output unit is configured to receive the first fixed potential, an output terminal of the fifth output unit is electrically connected to an output terminal of the second scanning-signal outputting module, a control terminal of the fifth output unit is electrically connected to the second node, an input terminal of the sixth output unit is configured to receive a third clock signal, and an output terminal of the sixth output unit is electrically connected to the output terminal of the second scanning-signal outputting module; and

said stage further comprises a second input module, wherein an input terminal of the second input module is configured to receive a second trigger signal, an output terminal of the second input module is coupled to a control terminal of the fourth output unit and a control terminal of the sixth output unit, and a control terminal of the second input module is configured to receive the first clock signal.

8.  The driving circuit according to claim 7, wherein: the output terminal of the second input module is coupled to the fourth output unit via a first voltage regulating module, the output terminal of the second input module is coupled to the sixth output unit via a second voltage regulating module, and a control terminal of the first voltage regulating module and a control terminal of the second voltage regulating module are both configured to receive a fixed potential.

9.  The driving circuit according to claim 5, wherein: said stage further comprises a reset module, an input terminal of the reset module is configured to receive the first fixed potential, an output terminal of the reset module is electrically connected to the first node, and a control terminal of the reset module is electrically connected to a line providing a reset signal.

10.  The driving circuit according to claim 7, wherein:

the second output terminal of the cascading module in the $j^{th}$ stage of the plurality of stages is electrically connected to the input terminal of the first input module in the $(j+1)^{th}$ stage of the plurality of stages;

the output terminal of the second scanning-signal outputting module in the $j^{th}$ stage is electrically connected to the input terminal of the second input module in the $(j+1)^{th}$ stage; and

$$j \geq 1.$$

11.  The driving circuit according to claim 5, wherein: the first input module comprises a first transistor, a first terminal of the first transistor is configured to receive the first trigger signal, a second terminal of the first transistor is electrically connected to the first node, and a gate of the first transistor is configured to receive the first clock signal.

12.  The driving circuit according to claim 6, wherein:

the first module comprises a second transistor and a third transistor;

a first terminal of the second transistor is configured to receive the first fixed potential, a second terminal of the second transistor is electrically connected to the second node, and a gate of the second transistor is electrically connected to the first node;

a first terminal of the third transistor is configured to receive the second fixed potential, a second terminal of the third transistor is electrically connected to the second node, and a gate of the third transistor is electrically connected to the first node;

the third transistor and the second transistor are different in type of majority carriers;

the second module comprises a fourth transistor and a fifth transistor;

a first terminal of the fourth transistor is configured to receive the first fixed potential, a second terminal of the fourth transistor is electrically connected to the output terminal of the second module, and a gate of the fourth transistor is electrically connected to the second node;

a first terminal of the fifth transistor is configured to receive the second fixed potential, a second terminal of the fifth transistor is electrically connected to the output terminal of the second module, and a gate of the fifth transistor is electrically connected to the second node;

the fourth transistor and the second transistor are identical in type of majority carriers, and the fifth transistor and the third transistor are identical in type of majority carriers.

13.  The driving circuit according to claim 7, wherein:

the first output unit comprises a sixth transistor, a first terminal of the sixth transistor is configured to receive the first fixed potential, a second terminal of the sixth transistor is electrically connected to the output terminal of the first output unit, and a gate of the sixth transistor is electrically connected to the output terminal of the gating module;

the second output unit comprises a seventh transistor, a first terminal of the seventh transistor is configured to receive the second fixed potential, a second terminal of the seventh transistor is electrically connected to the output terminal of the second output unit, a gate of the seventh transistor is electrically connected to the second output terminal of the cascading module, and the seventh transistor and the sixth transistor are different in type of majority carriers;

the third output unit comprises an eighth transistor, a first terminal of the eighth transistor is configured to receive the first fixed potential, a second terminal of the eighth transistor is electrically connected to the output terminal of the third output unit, and a gate of the eighth transistor is electrically connected to the second node;

the fourth output unit comprises a ninth transistor, a first terminal of the ninth transistor is configured to receive the second clock signal, a second terminal of the ninth transistor is electrically connected to the output terminal of the fourth output unit, a gate of the ninth transistor is electrically connected to the output terminal of the second input module, and the ninth transistor and the eighth transistor are identical in type of majority carriers;

the fifth output unit comprises a tenth transistor, a first terminal of the tenth transistor is configured to receive the first fixed potential, a second terminal of the tenth transistor is electrically connected to the output terminal of the fifth output unit, and a gate of the tenth transistor is electrically connected to the second node; and

the sixth output unit comprises an eleventh transistor, a first terminal of the eleventh transistor is configured to receive the third clock signal, a second terminal of the eleventh transistor is electrically connected to the output terminal of the sixth output unit, a gate of the eleventh transistor is electrically connected to the output terminal of the second input module, and the eleventh transistor and the tenth transistor are identical in type of majority carriers.

14. The driving circuit according to claim 7, wherein:
the second input module comprises a twelfth transistor, a first terminal of the twelfth transistor is configured to receive the second trigger signal, a second terminal of the twelfth transistor is electrically connected to the output terminal of the second input module, and a gate of the twelfth transistor is configured to receive the first clock signal.

15. The driving circuit according to claim 8, wherein:

the first voltage regulating module comprises a thirteenth transistor, wherein a first terminal of the thirteenth transistor is electrically connected to the output terminal of the second input module, a second terminal of the thirteenth transistor is electrically connected to the control terminal of the fourth output unit, and a gate of the thirteenth transistor is configured to receive the second fixed potential; and

the second voltage regulating module comprises a fourteenth transistor, wherein a first terminal of the fourteenth transistor is electrically connected to the output terminal of the second input module, a second terminal of the fourteenth transistor is electrically connected to the control terminal of the sixth output unit, and a gate of the fourteenth transistor is configured to receive the second fixed potential.

16. The driving circuit according to claim 9, wherein:
the reset module comprises a fifteenth transistor, a first terminal of the fifteenth transistor is configured to receive the first fixed potential, a second terminal of the fifteenth transistor is electrically connected to the first node, and a gate of the fifteenth transistor is electrically connected to the line providing the reset signal.

17. The driving circuit according to claim 5, wherein:

the gating module comprises a sixteenth transistor and a seventeenth transistor;
a first terminal of the sixteenth transistor is configured to receive the first fixed potential, a second terminal of the sixteenth transistor is electrically connected to a control terminal of the first output unit, and a gate of the sixteenth transistor is electrically connected to the second node; and
a first terminal of the seventeenth transistor is electrically connected to a line providing a gating signal, a second terminal of the seventeenth transistor is electrically connected to the control terminal of the first output unit, and a gate of the seventeenth transistor is electrically connected to the second output terminal of the cascading module.

18. The driving circuit according to claim 5, wherein:

the gating module comprises a sixteenth transistor, a seventeenth transistor, and an eighteenth transistor;
a first terminal of the sixteenth transistor is configured to receive the first fixed potential, a second terminal of the sixteenth transistor is electrically connected to a control terminal of the first output unit, and a gate of the sixteenth transistor is electrically connected to the second node; a first terminal of the seventeenth transistor is electrically connected to a third node, a second terminal of the seventeenth transistor is electrically connected to the control terminal of the first output unit, and a gate of the seventeenth transistor is electrically connected to the second output terminal of the cascading module; and a first terminal of the eighteenth transistor is electrically connected to a line providing a gating signal, a second terminal of the eighteenth transistor is electrically connected to the third node, and a gate of the eighteenth transistor is electrically connected to the second node.

19. The driving circuit according to claim 5, wherein:

the gating module comprises a sixteenth transistor, a seventeenth transistor, and an eighteenth transistor; a first terminal of the sixteenth transistor is configured to receive the first fixed potential, a second terminal of the sixteenth transistor is electrically connected to a control terminal of the first output unit, and a gate of the sixteenth transistor is electrically connected to a third node; a first terminal of the seventeenth transistor is connected to the second output terminal of the cascading module, a second terminal of the seventeenth transistor is electrically connected to the control terminal of the first output unit, and a gate of the seventeenth transistor is electrically connected to the third node; a first terminal of the eighteenth transistor is electrically connected to a line providing a gating signal, a second terminal of the eighteenth transistor is electrically connected to the third node, and a gate of the eighteenth transistor is electrically connected to the second node; and the sixteenth transistor and the seventeenth transistor are different in type of majority carriers, and the sixteenth transistor and the eighteenth transistor are identical in type of majority carriers.

20. The driving circuit according to claim 5, wherein:

the gating module comprises a sixteenth transistor, a seventeenth transistor, and an eighteenth transistor; a first terminal of the sixteenth transistor is electrically connected to the second output terminal of the cascading module, a second terminal of the sixteenth transistor is electrically connected to a control terminal of the first output unit, and a gate of the sixteenth transistor is electrically connected to a third node; a first terminal of the seventeenth transistor is configured to receive the first fixed potential, a second terminal of the seventeenth transistor is electrically connected to the control terminal of the first output unit, and a gate of the seventeenth transistor is electrically connected to the third node; a first terminal of the eighteenth transistor is connected to a line providing a gating signal, a second terminal of the eighteenth transistor is electrically connected to the third node, and a gate electrically of the eighteenth transistor is connected to the second node; and the sixteenth transistor and the seventeenth transistor are different in type of majority carriers, and the sixteenth transistor and the eighteenth transistor are identical in type of majority carriers.

21. The driving circuit according to claim 5, wherein:

the gating module comprises a sixteenth transistor, a seventeenth transistor, and an eighteenth transistor; a first terminal of the sixteenth transistor is configured to receive the first fixed potential, a second terminal of the sixteenth transistor is electrically connected to a control terminal of the first output unit, and a gate of the sixteenth transistor is electrically connected to the second output terminal of the cascading module; a first terminal of the seventeenth transistor is electrically connected to a third node, a second terminal of the seventeenth transistor is electrically connected to the control terminal of the first output unit, and a gate of the seventeenth transistor is electrically connected to the second output terminal of the cascading module; and a first terminal of the eighteenth transistor is electrically connected to a line providing a gating signal, a second terminal of the eighteenth transistor is electrically connected to the third node, and a gate of the eighteenth transistor is electrically connected to the second node; and the sixteenth transistor and the seventeenth transistor are different in type of majority carriers, and the sixteenth transistor and the eighteenth transistor are different in type of majority carriers.

22. The driving circuit according to any one of claims 18 to 21, wherein:
the gating module further comprises a first capacitor, a terminal of the first capacitor is electrically connected to the third node, and another terminal of the first capacitor is configured to receive a fixed potential.

23. The driving circuit according to any one of claims 18 to 21, wherein:
the gating module comprises a first logic inverter and a second logic inverter, an input terminal of the first logic inverter is electrically connected to an output terminal of the second logic inverter and the third node, and an output terminal of the first logic inverter electrically connected to an input terminal of the second logic inverter.

24. The driving circuit according to claim 7, wherein:

said stage further comprise a second capacitor, a third capacitor, and a fourth capacitor;
a terminal of the second capacitor is electrically connected to the output terminal of the fourth output unit, and another terminal of the second capacitor is electrically connected to the control terminal of the fourth output unit;
a terminal of the third capacitor has one terminal electrically connected to the output terminal of the sixth output unit, and another terminal of the third capacitor is electrically connected to the control terminal of the sixth output unit; and
a terminal of the fourth capacitor is electrically connected to the first node, and another terminal of the fourth capacitor is configured to receive a fixed potential.

25. The driving circuit according to claim 7, wherein:

in each stage having an odd sequential number among the plurality of stages, the control terminal of the first input module and the control terminal of the second input module are both electrically connected to a first clock-signal line, the input terminal of the fourth output unit is electrically connected to a second clock-signal line, and the input terminal of the sixth output unit is electrically connected to a third clock-signal line; and
in each stage having an even sequential number among the plurality of stages, the control terminal of the first input module and the control terminal of the second input module are both electrically connected to the third clock-signal line, the input terminal of the fourth output unit is electrically connected to a fourth clock-signal line, and the input terminal of the sixth output unit is electrically connected to the first clock-signal line.

26. The driving circuit according to claim 7, wherein:

in the $j^{th}$ stage among the plurality of stages, the control terminal of the first input module and the control terminal of the second input module are both electrically connected to a first clock-signal line, the input terminal of the fourth output unit is electrically connected to a second clock-signal line, and the input terminal of the sixth output unit is electrically connected to a third clock-signal line;
in the $(j+1)^{th}$ stage among the plurality of stages, the control terminal of the first input module and the control terminal of the second input module are both electrically connected to the third clock-signal line, the input terminal of the fourth output unit is electrically connected to the first clock-signal line, and the input terminal of the sixth output unit is electrically connected to the second clock-signal line;
in the $(j+2)^{th}$ stage among the plurality of stages, the control terminal of the first input module and the control terminal of the second input module are both electrically connected to the second clock-signal line, the input terminal of the fourth output unit is electrically connected to the third clock-signal line, and the input terminal of the sixth output unit is electrically connected to the first clock-signal line; and

$$j \geq 1.$$

27. The driving circuit according to claim 7, wherein:

in the $j^{th}$ stage among the plurality of stages, the control terminal of the first input module and the control terminal of the second input module are both electrically connected to a first clock-signal line, the input terminal of the fourth output unit is electrically connected to a second clock-signal line, and the input terminal of the sixth output unit is electrically connected to a third clock-signal line;
in the $(j+1)^{th}$ stage among the plurality of stages, the control terminal of the first input module and the control terminal of the second input module are both electrically connected to the third clock-signal line, the input terminal of the fourth output unit is electrically connected to a fourth clock-signal line, and the input terminal of the sixth output unit is electrically connected to a fifth clock-signal line;
in the $(j+2)^{th}$ stage among the plurality of stages, the control terminal of the first input module and the control terminal of the second input module are both electrically connected to the fifth clock-signal line, the input terminal of the fourth output unit is electrically connected to the first clock-signal line, and the input terminal of the sixth output unit is electrically connected to the second clock-signal line;

in the (j+3)$^{th}$ stage among the plurality of stages, the control terminal of the first input module and the control terminal of the second input module are both electrically connected to the second clock-signal line, the input terminal of the fourth output unit is electrically connected to the third clock-signal line, and the input terminal of the sixth output unit is electrically connected to the fourth clock-signal line;

in the (j+4)$^{th}$ stage among the plurality of stages, the control terminal of the first input module and the control terminal of the second input module are both electrically connected to the fourth clock-signal line, the input terminal of the fourth output unit is electrically connected to the fifth clock-signal line, and the input terminal of the sixth output unit is electrically connected to the first clock-signal line; and

$$j \geq 1.$$

28. The driving circuit according to claim 5, wherein:

the gating module is electrically connected to a gating-signal line, and the gating module is further configured to transmit the control signal to the first output unit according to the gating signal provided by the gating-signal line;

the driving circuit is electrically connected to at least two gating-signal lines, and the at least two gating-signal lines comprise a first gating-signal line and a second gating-signal line;

the plurality of stages comprises cascaded stages in a first region, cascaded stages in a second region, and cascaded stages in a third region, and the second region is located between the first region and the third region;

the stages in the first region and the stages in the second region are both electrically connected to the first gating-signal line, and the stages in the second region are electrically connected to the second gating-signal line; and

in an operation cycle of the driving circuit, the output terminal of the first signal outputting module in a last stage among the stages in the first region outputs a first enable signal, the output terminal of the first signal outputting module in a foremost stage of among the stages in the third region outputs a second enable, and the active level in the second enable signal starts after the active level of the first enable signal ends.

29. The driving circuit according to claim 5, wherein:

the second signal outputting module comprises a first scanning-signal outputting module and a second scanning-signal outputting module;

the first scanning-signal outputting module comprises a third output unit and a fourth output unit;

an input terminal of the third output unit is configured to receive the first fixed potential, an output terminal of the third output unit is electrically connected to an output terminal of the first scanning-signal outputting module, and a control terminal of the third output unit is electrically connected to the second node;

an input terminal of the fourth output unit is configured to receive a second clock signal, and an output terminal of the fourth output unit is electrically connected to the output terminal of the first scanning-signal outputting module;

the second scanning-signal outputting module comprises a fifth output unit and a sixth output unit;

an input terminal of the fifth output unit is configured to receive the first fixed potential, an output terminal of the fifth output unit is electrically connected to an output terminal of the second scanning-signal outputting module, and a control terminal of the fifth output unit is electrically connected to the second node;

an input terminal of the sixth output unit is configured to receive a third clock signal, and an output terminal of the sixth output unit is electrically connected to the output terminal of the second scanning-signal outputting module; and said stage further comprises a second input module, wherein an input terminal of the second input module is electrically connected to the second output terminal of the cascading module, an output terminal of the second input module is coupled to a control terminal of the fourth output unit and a control terminal of the sixth output unit, and a control terminal of the second input module is configured to receive the first clock signal.

30. The driving circuit according to claim 7 or 29, wherein:
said stage further comprises a third voltage regulating module, an input terminal of the third voltage regulating module is configured to receive the first fixed potential, an output terminal of the third voltage regulating module is electrically connected to the output terminal of the second input module, and a control terminal of the third voltage regulating module is electrically connected to the second node.

31. A method for controlling the driving circuit according to any one of claims 1 to 30, wherein operation of the driving circuit comprises a first enabling phase and a second enabling phase, and the driving method comprises:

outputting, in the first enabling phase, an active level from the first signal outputting module; and outputting, in the second enabling phase, the active level from the second signal outputting module, wherein the first enabling phase and the second enabling phase do not overlap temporally, or the second enabling phase is within the first enabling phase.

32. The driving method according to claim 31, wherein:

the second signal outputting module comprises a first scanning-signal outputting module and a second scanning-signal outputting module; each pixel circuit, of which the gate of the gate resetting transistor are electrically connected to the first scanning-signal outputting module, and each pixel circuit, of which the gate of the gate resetting transistor is electrically connected to the second scanning-signal outputting module, are located in different rows of the pixel circuits; the second enabling phase comprises a first sub-phase and a second sub-phase; and outputting the active level from the second signal outputting module comprises:

outputting, in the first sub-phase, the active level from the first scanning-signal outputting module; and outputting, in the second sub-phase, the active level from the second scanning-signal outputting module; wherein the first sub-phase is after the second sub-phase.

33. A display panel, comprising the driving circuit according to any one of claims 1 to 30.

34. A display apparatus, comprising the display panel according to claim 33.

100

FIG. 1

10

First signal outputting module

11

SN_OUT

Second signal outputting module

12

SP_OUT

FIG. 2

PVDD    Data

DL2     DL1

02

M4    M2    SP    10/12

Cst

Vref1  SL1  M1    Md

10/11  S1N

S2N   M3

EM    M5

Vref2 SL2  M6

03

FIG. 3

FIG. 4

10

First signal outputting module

SN_OUT

First scanning-signal outputting module

SP1_OUT

Second scanning-signal outputting module

SP2_OUT

11

12/121

12/122

FIG. 5

10

FIG. 6

FIG. 7

10

FIG. 8

EP 4 779 621 A1

10

CK1

13

First input module

SN_IN

N1

VGH

Reset module

RST

19

VGH

First module

VGH

Second module

N2

141

VGL

142

VGL

14

SN_NEXT

15

Gating module

VGH

First output unit

111

SN_OUT

Second output unit

11

112

VGL

SP_IN

CK1

Second input module

16

17

VGL

First voltage regulator module

12/121

VGH

1211

Third output unit

SP1_OUT

Fourth output unit

1212

CK2

Second voltage regulator module

18

VGL

VGH

1221

Fifth output unit

SP2_OUT

Sixth output unit

1222

CK3

12/122

FIG. 9

FIG. 10

FIG. 11

FIG. 12

FIG. 13

FIG. 14

FIG. 15

10

FIG. 16

FIG. 17

FIG. 18

FIG. 19

FIG. 20

FIG. 21

FIG. 22

CTRL1  CTRL2

CTRL

10

101

CTRL

10/101B

CTRL

102

CTRL

CTRL

10/103A

103

CTRL

FIG. 23

FIG. 24

FIG. 25

10

FIG. 26

10

FIG. 27

B1

Output, in a first enabling phase, an active level from a first signal outputting module

B2

Output, in a first enabling phase, an active level from a first signal outputting module

FIG. 28

200

100

FIG. 29

## INTERNATIONAL SEARCH REPORT

| | International application No. |
|---|---|
| | **PCT/CN2025/113450** |

**A. CLASSIFICATION OF SUBJECT MATTER**

G09G3/30(2006.01)i

According to International Patent Classification (IPC) or to both national classification and IPC

**B. FIELDS SEARCHED**

Minimum documentation searched (classification system followed by classification symbols)

IPC: G09G

Documentation searched other than minimum documentation to the extent that such documents are included in the fields searched

Electronic data base consulted during the international search (name of data base and, where practicable, search terms used)

CNTXT, ENTXT, WPABS, CNKI: 天马微电子, 张文帅, 显示, 移位寄存, 栅极驱动, 扫描驱动, 窄边框, 复位, 初始化, 阈值, display, shift, register, gate, scan, narrow, edge, reset+, rst, init, threshold

**C. DOCUMENTS CONSIDERED TO BE RELEVANT**

| Category* | Citation of document, with indication, where appropriate, of the relevant passages | Relevant to claim No. |
|---|---|---|
| X | CN 119007649 A (HONOR DEVICE CO., LTD.) 22 November 2024 (2024-11-22) description, paragraphs [0055]-[0119], and figures 1-15 | 1-4, 31-34 |
| A | CN 114300029 A (BOE TECHNOLOGY GROUP CO., LTD. et al.) 08 April 2022 (2022-04-08) entire document | 1-34 |
| A | CN 115088078 A (BOE TECHNOLOGY GROUP CO., LTD.) 20 September 2022 (2022-09-20) entire document | 1-34 |
| A | JP 2005251348 A (CASIO COMPUTER CO., LTD.) 15 September 2005 (2005-09-15) entire document | 1-34 |
| A | JP 2017097174 A (SEIKO EPSON CORP.) 01 June 2017 (2017-06-01) entire document | 1-34 |

☐ Further documents are listed in the continuation of Box C.   ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **12 November 2025** | **19 November 2025** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

# EP 4 779 621 A1

**INTERNATIONAL SEARCH REPORT**
Information on patent family members

International application No.

**PCT/CN2025/113450**

| Patent document cited in search report | | | Publication date (day/month/year) | Patent family member(s) | | | Publication date (day/month/year) |
|---|---|---|---|---|---|---|---|
| CN | 119007649 | A | 22 November 2024 | None | | | |
| CN | 114300029 | A | 08 April 2022 | WO | 2021022554 | A1 | 11 February 2021 |
| | | | | CN | 112639947 | A | 09 April 2021 |
| | | | | US | 2021201751 | A1 | 01 July 2021 |
| | | | | US | 11244595 | B2 | 08 February 2022 |
| | | | | CN | 112639947 | B | 18 November 2022 |
| | | | | US | 2024346973 | A1 | 17 October 2024 |
| | | | | US | 12417725 | B2 | 16 September 2025 |
| CN | 115088078 | A | 20 September 2022 | WO | 2022151082 | A1 | 21 July 2022 |
| | | | | GB | 2609580 | A | 08 February 2023 |
| | | | | US | 2023162684 | A1 | 25 May 2023 |
| | | | | US | 11854489 | B2 | 26 December 2023 |
| | | | | US | 2024029660 | A1 | 25 January 2024 |
| | | | | US | 12148393 | B2 | 19 November 2024 |
| | | | | CN | 115088078 | B | 28 March 2025 |
| JP | 2005251348 | A | 15 September 2005 | None | | | |
| JP | 2017097174 | A | 01 June 2017 | JP | 6631197 | B2 | 15 January 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202411748803